# EUROPEAN PATENT APPLICATION

(11) **EP 4 294 153 A1**
(43) Date of publication of application: **20.12.2023**
(21) Application number: 23178764.9
(22) Date of filing: 12.06.2023
(51) Int. Cl.: H10K 50/85, H10K 50/854, H10K 59/80

(54) **ORGANIC ELECTROLUMINESCENT DEVICES**

(30) Priority: 17.06.2022 US 202263353392 P; 09.08.2022 US 202263396320 P; 31.05.2023 US 202318203905
(71) Applicant: Universal Display Corporation, Ewing, NJ 08618 (US)
(72) Inventor: MUNDOOR, Haridas, Ewing, NJ, 08618 (US); THOMPSON, Nicholas J., Ewing, NJ, 08618 (US); MENON, Vinod M., Ewing, NJ, 08618 (US)
(74) Representative: Maiwald GmbH

(57) **Abstract**

Embodiments of the disclosed subject matter provide a device that may include an organic light emitting device (OLED) having a substrate (110), a first electrode (115) disposed over the substrate, a second electrode (160) disposed over the first electrode, and an organic emissive layer (135) having a first surface positioned over a second surface is disposed between the first electrode and the second electrode. A nanoparticle layer may be disposed over the organic emissive layer and has a first surface that is positioned over a second surface. The nanoparticle layer may include a first plurality of nanoparticles comprising a dielectric material, and a surrounding medium. A distance from the second surface of the nanoparticle layer to the first surface of the organic emissive layer may be not more than 50 nm, and there may be a difference of at least 1.0 between a refractive index of the dielectric material and the surrounding medium.

## Description

### CROSS-REFERENCE TO RELATED APPLICATIONS

This application claims priority to U.S. Patent Application Serial No. 63/396,320, filed August 9, 2022, and U.S. Patent Application Serial No. 63/353,392, filed June 17, 2022, the entire contents of each are incorporated herein by reference.

### FIELD

The present invention relates to devices and techniques for fabricating organic emissive devices, such as organic light emitting diodes, for low-loss OLEDs which utilize Mie scattering of nanoparticles and increase the efficiency of OLED devices, and devices and techniques including the same.

### BACKGROUND

Opto-electronic devices that make use of organic materials are becoming increasingly desirable for a number of reasons. Many of the materials used to make such devices are relatively inexpensive, so organic opto-electronic devices have the potential for cost advantages over inorganic devices. In addition, the inherent properties of organic materials, such as their flexibility, may make them well suited for particular applications such as fabrication on a flexible substrate. Examples of organic opto-electronic devices include organic light emitting diodes/devices (OLEDs), organic phototransistors, organic photovoltaic cells, and organic photodetectors. For OLEDs, the organic materials may have performance advantages over conventional materials. For example, the wavelength at which an organic emissive layer emits light may generally be readily tuned with appropriate dopants.

OLEDs make use of thin organic films that emit light when voltage is applied across the device. OLEDs are becoming an increasingly interesting technology for use in applications such as flat panel displays, illumination, and backlighting. Several OLED materials and configurations are described in U.S. Pat. Nos. 5,844,363, 6,303,238, and 5,707,745, which are incorporated herein by reference in their entirety.

One application for phosphorescent emissive molecules is a full color display. Industry standards for such a display call for pixels adapted to emit particular colors, referred to as "saturated" colors. In particular, these standards call for saturated red, green, and blue pixels. Alternatively, the OLED can be designed to emit white light. In conventional liquid crystal displays emission from a white backlight is filtered using absorption filters to produce red, green and blue emission. The same technique can also be used with OLEDs. The white OLED can be either a single EML device or a stack structure. Color may be measured using CIE coordinates, which are well known to the art.

As used herein, the term "organic" includes polymeric materials as well as small molecule organic materials that may be used to fabricate organic opto-electronic devices. "Small molecule" refers to any organic material that is not a polymer, and "small molecules" may actually be quite large. Small molecules may include repeat units in some circumstances. For example, using a long chain alkyl group as a substituent does not remove a molecule from the "small molecule" class. Small molecules may also be incorporated into polymers, for example as a pendent group on a polymer backbone or as a part of the backbone. Small molecules may also serve as the core moiety of a dendrimer, which consists of a series of chemical shells built on the core moiety. The core moiety of a dendrimer may be a fluorescent or phosphorescent small molecule emitter. A dendrimer may be a "small molecule," and it is believed that all dendrimers currently used in the field of OLEDs are small molecules.

As used herein, "top" means furthest away from the substrate, while "bottom" means closest to the substrate. Where a first layer is described as "disposed over" a second layer, the first layer is disposed further away from substrate. There may be other layers between the first and second layer, unless it is specified that the first layer is "in contact with" the second layer. For example, a cathode may be described as "disposed over" an anode, even though there are various organic layers in between.

As used herein, "solution processible" means capable of being dissolved, dispersed, or transported in and/or deposited from a liquid medium, either in solution or suspension form.

A ligand may be referred to as "photoactive" when it is believed that the ligand directly contributes to the photoactive properties of an emissive material. A ligand may be referred to as "ancillary" when it is believed that the ligand does not contribute to the photoactive properties of an emissive material, although an ancillary ligand may alter the properties of a photoactive ligand.

As used herein, and as would be generally understood by one skilled in the art, a first "Highest Occupied Molecular Orbital" (HOMO) or "Lowest Unoccupied Molecular Orbital" (LUMO) energy level is "greater than" or "higher than" a second HOMO or LUMO energy level if the first energy level is closer to the vacuum energy level. Since ionization potentials (IP) are measured as a negative energy relative to a vacuum level, a higher HOMO energy level corresponds to an IP having a smaller absolute value (an IP that is less negative). Similarly, a higher LUMO energy level corresponds to an electron affinity (EA) having a smaller absolute value (an EA that is less negative). On a conventional energy level diagram, with the vacuum level at the top, the LUMO energy level of a material is higher than the HOMO energy level of the same material. A "higher" HOMO or LUMO energy level appears closer to the top of such a diagram than a "lower" HOMO or LUMO energy level.

As used herein, and as would be generally understood by one skilled in the art, a first work function is "greater than" or "higher than" a second work function if the first work function has a higher absolute value. Because work functions are generally measured as negative numbers relative to vacuum level, this means that a "higher" work function is more negative. On a conventional energy level diagram, with the vacuum level at the top, a "higher" work function is illustrated as further away from the vacuum level in the downward direction. Thus, the definitions of HOMO and LUMO energy levels follow a different convention than work functions.

Layers, materials, regions, and devices may be described herein in reference to the color of light they emit. In general, as used herein, an emissive region that is described as producing a specific color of light may include one or more emissive layers disposed over each other in a stack.

As used herein, a "red" layer, material, region, or device refers to one that emits light in the range of about 580-700 nm or having a highest peak in its emission spectrum in that region. Similarly, a "green" layer, material, region, or device refers to one that emits or has an emission spectrum with a peak wavelength in the range of about 500-600 nm; a "blue" layer, material, or device refers to one that emits or has an emission spectrum with a peak wavelength in the range of about 400-500nm; and a "yellow" layer, material, region, or device refers to one that has an emission spectrum with a peak wavelength in the range of about 540-600 nm. In some arrangements, separate regions, layers, materials, regions, or devices may provide separate "deep blue" and a "light blue" light. As used herein, in arrangements that provide separate "light blue" and "deep blue", the "deep blue" component refers to one having a peak emission wavelength that is at least about 4 nm less than the peak emission wavelength of the "light blue" component. Typically, a "light blue" component has a peak emission wavelength in the range of about 465-500 nm, and a "deep blue" component has a peak emission wavelength in the range of about 400-470 nm, though these ranges may vary for some configurations. Similarly, a color altering layer refers to a layer that converts or modifies another color of light to light having a wavelength as specified for that color. For example, a "red" color filter refers to a filter that results in light having a wavelength in the range of about 580-700 nm. In general, there are two classes of color altering layers: color filters that modify a spectrum by removing unwanted wavelengths of light, and color changing layers that convert photons of higher energy to lower energy. A component "of a color" refers to a component that, when activated or used, produces or otherwise emits light having a particular color as previously described. For example, a "first emissive region of a first color" and a "second emissive region of a second color different than the first color" describes two emissive regions that, when activated within a device, emit two different colors as previously described.

As used herein, emissive materials, layers, and regions may be distinguished from one another and from other structures based upon light initially generated by the material, layer or region, as opposed to light eventually emitted by the same or a different structure. The initial light generation typically is the result of an energy level change resulting in emission of a photon. For example, an organic emissive material may initially generate blue light, which may be converted by a color filter, quantum dot or other structure to red or green light, such that a complete emissive stack or sub-pixel emits the red or green light. In this case the initial emissive material or layer may be referred to as a "blue" component, even though the sub-pixel is a "red" or "green" component.

In some cases, it may be preferable to describe the color of a component such as an emissive region, sub-pixel, color altering layer, or the like, in terms of 1931 CIE coordinates. For example, a yellow emissive material may have multiple peak emission wavelengths, one in or near an edge of the "green" region, and one within or near an edge of the "red" region as previously described. Accordingly, as used herein, each color term also corresponds to a shape in the 1931 CIE coordinate color space. The shape in 1931 CIE color space is constructed by following the locus between two color points and any additional interior points. For example, interior shape parameters for red, green, blue, and yellow may be defined as shown below:

| **Color** | **CIE Shape Parameters** |
|---|---|
| Central Red | Locus: [0.6270,0.3725];[0.7347,0.2653]; |
| | lnterior:[0.5086,0.2657] |
| Central Green | Locus: [0.0326,0.3530];[0.3731,0.6245]; |
| | Interior: [0.2268,0.3321 |
| Central Blue | Locus: [0.1746,0.0052];[0.0326,0.3530]; |
| | Interior:[0.2268,0.3321] |
| Central Yellow | Locus: [0.373 I,0.6245];[0.6270,0.3725]; |
| | Interior: [0.3 700,0.4087];[0.2886,0.4572] |

More details on OLEDs, and the definitions described above, can be found in US Pat. No. 7,279,704, which is incorporated herein by reference in its entirety.

### SUMMARY

According to an embodiment, an organic light emitting diode/device (OLED) is also provided. The OLED can include an anode, a cathode, and an organic layer, disposed between the anode and the cathode. According to an embodiment, the organic light emitting device is incorporated into one or more device selected from a consumer product, an electronic component module, and/or a lighting panel.

According to an embodiment, a device may include an organic light emitting device (OLED) having a substrate, a first electrode disposed over the substrate, a second electrode disposed over the first electrode, and an organic emissive layer disposed between the first electrode and the second electrode, where the organic emissive layer may have a first surface positioned over a second surface. A nanoparticle layer may be disposed over the organic emissive layer, and the nanoparticle layer may have a first surface that is positioned over a second surface. The nanoparticle layer may include a first plurality of nanoparticles comprising a dielectric material, and a surrounding medium. A distance from the second surface of the nanoparticle layer to the first surface of the organic emissive layer may not be more than 50 nm, and there may be a difference of at least 1.0 between a refractive index of the dielectric material and the surrounding medium.

The first plurality of nanoparticles may be disposed in an outcoupling layer disposed over the second electrode.

At least some of the first plurality of nanoparticles may be integrated with the second electrode.

The arrangement of the first plurality of nanoparticles may result in an external quantum efficiency (EQE) of at least 15%.

The first plurality of nanoparticles may include at least one nanoparticle having a Mie scattering efficiency of 2-8 based on a size of the nanoparticles, a shape of the nanoparticles, and/or a material refractive index of the nanoparticles.

A refractive index of the first plurality of nanoparticles may be at least 1.9, at least 2.1, at least 2.5, and/or less than 3.5.

The first plurality of nanoparticles may include silicon, silicon nitride, boron nitride, silicon carbide, carbon, diamond, zinc sulfide, zinc selenide, germanium, zinc telluride, potassium niobate, titanium oxide, antimony oxide, niobium pentoxide, tantalum pentoxide, vanadium oxide, vanadium pentoxide, gallium phosphate, bismuth oxide, gallium arsenide, and/or aluminum gallium.

The first plurality of nanoparticles may have a single configuration or may have multiparticle configurations.

The first plurality of nanoparticles of the device may include two or more materials, each of the two or more materials having a different refractive index, homogeneously or inhomogeneously distributed within the outcoupling layer, where at least one of the two or more materials creates the difference of at least 1.0 between the refractive index of the at least one of the two or more materials and the surrounding medium.

A shape of the nanoparticles may be at least one of a cube, a cylinder, a sphere, a spheroid, a parallelopiped shape, a rod-shape, a star-shape, a pyramidal shape, an amorphous shape, and/or a multi-faceted three-dimensional object.

Differences between at least two of the first plurality of nanoparticles include sizes, shapes, and/or indices of refraction.

The first plurality of nanoparticles may be configured in a periodic array. A scattering wavelength and efficiency of the first plurality of nanoparticles in the periodic array may be based on array periodicity, a shape of the particles, a size of the particles, and/or a symmetry of the array. At least two nanoparticles in the periodic array may have the same shape, different shapes, the same size, different sizes, the same refractive index values, and/or different refractive index values. A lattice periodicity of the periodic array may be configured to output a non-Lambertian emission from the device. In some embodiments, the first plurality of nanoparticles of the periodic array may have a shape that is a conical shape, a square pyramid shape, a shape having a square base and a curved face, and/or a parabolic cone shape. The shape of the first plurality of nanoparticles may have a tapered end facing away from the OLED, and the first plurality of nanoparticles may be integrated with the first electrode or the second electrode. The largest in-plane dimension of the first plurality of nanoparticles may be at least 100 nm, at least 200 nm, at least 300 nm, and/or at least 500 nm, where the in-plane dimension is in a plane that is horizontal to the substrate. An out-of-plane dimension of the first plurality of nanoparticles may be at least 150 nm, at least 300 nm, at least 600 nm, and/or at least 1 µm, where the out-of-plane dimension is in a plane perpendicular to the substrate. The shortest edge-to-edge spacing between the first plurality of nanoparticles may be less than 100 nm, less than 50 nm, less than 25 nm, and/or may be less than 10 nm. In some embodiments, the first plurality of nanoparticles of the periodic array may be cubic, cylindrical, cuboidal, or spherical. A center-to-center interparticle spacing of the first plurality of nanoparticles in any ordered direction may be less than 300nm, less than 400 nm, less than 500 nm, and/or less than 600 nm. An in-plane dimension of the first plurality of nanoparticles may be at least 100 nm, at least 200 nm, at least 300 nm, and/or at least 500 nm. An out-of-plane dimension of the first plurality of nanoparticles may be at least 50 nm, at least 150 nm, at least 300 nm, and/or at least 500 nm.

The device may include a transparent dielectric layer having a thickness at least 2 nm but not more than 50 nm minus a thickness of the electrode, where the transparent dielectric layer is disposed between the second electrode and the nanoparticle layer. A refractive index of the dielectric material may be less than 1.2, less than 1.5, less than 2, and/or less than 2.5.

The device may include a transparent layer disposed on the first plurality of nanoparticles. The transparent layer may include a dielectric material having a refractive index less than 1.2, less than 1.5, less than 2, less than 2.5, and/or less than 3. The light transmission through a 50 nm thick dielectric material of the transparent layer may be at least 30% for any wavelength longer than 400 nm in the visible region of the electromagnetic spectrum.

The device may include a second plurality of nanoparticles comprising a dielectric material that is disposed over the first plurality of nanoparticles that are disposed over the second electrode. A first layer may be disposed over the first plurality of nanoparticles, and a second layer disposed over the second plurality of nanoparticles.

The device may have a first side and a second side. The first electrode may include a reflective metal layer to reflect light to the first side of the device. The second electrode may be a transparent layer, and the nanoparticle layer is disposed over the transparent layer. The organic emissive layer may be disposed at least 75 nm from the reflective metal layer. A thickness of the reflective metal layer may be at least 50 nm, at least 100 nm, at least 150 nm, at least 200 nm, and/or less than 300 nm.

The device may have a first side and a second side, and light is emitted from both the first side and the second side.

The device may include a reflective layer disposed on the second side to direct emission of light to the first side of the device.

The device may include a distributed Bragg reflector (DBR) stack disposed to reflect light from a second side of the device. The substrate has a first side and a second side, and the DBR stack is disposed on the second side of the substrate. An OLED stack may be disposed on the first side of the substrate. In some embodiments, the DBR may be disposed on the first side of the substrate, and the OLED may be disposed on the DBR. The DBR stack may include at least 2 pair of layers, at least three pairs of layer, at least 5 pairs of layers, at least 10 pairs of layers, and/or not more than 20 pairs of layers. The number of pairs of layers may be based on a refractive index difference between a first index material layer and a second index material layer. The first index material and second index material may form a pair. The first index material may be made of one material type with particular index value and second index material will be made of different material with index value different from first index material.

The first electrode and/or the second electrode may be a transparent electrode, where the first plurality of nanoparticles may be disposed over the second electrode. An in-plane dimension of the nanoparticles may be between 200-400 nm, 400-600nm, and/or 600-800 nm, where the in-plane dimension is in a plane that is horizontal to the substrate. A distance in an out-of-plane dimension between the nanoparticles may be between 25-75 nm, 75-200 nm, 200-400 nm, and/or 400-600 nm, where the out-of-plane dimension may be in a plane that is perpendicular to the substrate.

An in-plane dimension of the nanoparticles may be 200-400 nm, 400-600nm, and/or 600-800 nm, wherein the -plane dimension is in a plane that is horizontal to the substrate. A distance in an out-of-plane dimension between the nanoparticles may be 25-75 nm, 75-200nm, 200-400 nm, and/or 400-600 nm, where the out-of-plane dimension is in a plane perpendicular to the substrate.

The OLED may be a stack having a plurality of layers, and a thickness of the stack is 50 - 600 nm.

The organic emissive layer may have a thickness that is at least 0.2 nm, but not more than 75 nm.

The organic emissive layer of the device is disposed from the second electrode by at least 10 nm, at least 100 nm, at least 300 nm, and/or at least 600 nm.

The arrangement of the first plurality of nanoparticles may result in an external quantum efficiency (EQE) of at least 30%.

The first plurality of nanoparticles of the device may be arranged to have an external quantum efficiency (EQE) of at least 50%.

The first electrode and/or the second electrode of the device may include indium tin oxide, fluorine doped tin oxide, indium doped zinc oxide, Aluminum Zinc Oxide, indium-doped cadmium oxide, barium stannate, carbon nanotubes, graphene, multilayer graphene, single layer graphene, graphene oxide, metallic nano particle or nanowire impregnated materials, as well as conductive polymers such as polyacetylene, polypyrrole, polyindole, polyaniline, Poly(p-phenylene vinylene), and/or poly(3-alkylthiophenes), (poly(3,4-ethylenedioxythiophene)).

The first electrode and/or the second electrode of the device may include polymers, oxide materials, nano-sized metallic nanoparticles, and/or metal nanowires.

The first electrode and/or the second electrode may include a multilayer that is indium tin oxide, fluorine doped tin oxide, indium doped zinc oxide, aluminum zinc oxide, indium-doped cadmium oxide, barium stannate, carbon nanotubes, graphene, multilayer graphene, single layer graphene, graphene oxide, metallic nanoparticle or nanowire impregnated materials, polyacetylene, polypyrrole, polyindole, polyaniline, Poly(p-phenylene vinylene), and/or poly(3-alkylthiophenes), (poly(3,4-ethylenedioxythiophene)). The first electrode and/or the second electrode may include a metal layer having a thickness of 2-5 nm and/or 6-10 nm. The organic emissive layer may be disposed at least 75 nm from the metal layer.

The second electrode of the device may be a metallic electrode, and the nanoparticle layer may be disposed over the metallic electrode. The first plurality of nanoparticles of the nanoparticle layer may be configured as dimers, trimers, and/or a plurality of levels of units to be configured to output a non-Lambertian emission. The organic emissive layer of the device may a first surface positioned over a second surface, the metallic electrode of the device may have a first surface positioned over a second surface, and the distance from the first surface of the organic emissive layer to a second surface of the metallic electrode is at least one selected from the group consisting of: less than 10 nm, less than 15 nm, less than 20 nm, less than 30 nm, and less than 40 nm. The metallic electrode of the device may have one or more metallic layers of silver, one or more metallic layers of aluminum, and/or one or more metallic layers of gold. A distance between the first surface and the second surface of the metallic electrode may be less than 20 nm, less than 30 nm, and/or less than 50 nm. The organic emissive layer may have a thickness that is less than 1 nm, less than 2 nm, less than 5 nm, and/or less than 10 nm. The organic emissive layer of the device may have a first surface positioned over a second surface, the metallic electrode of the device may have a first surface positioned over a second surface, and a distance from the first surface of the organic emissive layer to the second surface of the nanoparticle layer may be at least 20 nm, at least 30 nm, at least 40 nm, and/or at least 50 nm. A dielectric layer may be disposed between the metallic electrode and the nanoparticle layer that has a thickness that is less than 10 nm, less than 5 nm, and/or at least 2 nm. A refractive index of the dielectric layer may be at least 1.5, at least 1.75, at least 2, at least 2.5, and/or greater than 2.5.

A thickness of the second electrode may be 10-20 nm, 20-50 nm, and/or 50 -100 nm.

The substrate of the device may be a transparent material.

The device may have a first side and a second side, where the substrate includes a reflective material to reflect the light to the second side of the device.

The dielectric material of the first plurality of nanoparticles may absorb not more than 50% of the light energy in a spectral range of outcoupling.

The dielectric material of the first plurality of nanoparticles may absorb not more than 20% of the light energy in a spectral range of outcoupling.

According to an embodiment, a consumer electronic device may include a device may include an organic light emitting device (OLED) having a substrate, a first electrode disposed over the substrate, a second electrode disposed over the first electrode, and an organic emissive layer disposed between the first electrode and the second electrode, where the organic emissive layer may have a first surface positioned over a second surface. A nanoparticle layer may be disposed over the organic emissive layer, and the nanoparticle layer may have a first surface that is positioned over a second surface. The nanoparticle layer may include a plurality of nanoparticles comprising a dielectric material, and a surrounding medium. A distance from the second surface of the nanoparticle layer to the first surface of the organic emissive layer may not be more than 50 nm, and there may be a difference of at least 1.0 between a refractive index of the dielectric material and the surrounding medium.

The device may be a flat panel display, a curved display, a computer monitor, a medical monitor, a television, a billboard, a light for interior or exterior illumination and/or signaling, a heads-up display, a fully or partially transparent display, a flexible display, a rollable display, a foldable display, a stretchable display, a laser printer, a telephone, a cell phone, tablet, a phablet, a personal digital assistant (PDA), a wearable device, a laptop computer, a digital camera, a camcorder, a viewfinder, a micro-display that is less than 2 inches diagonal, a 3-D display, a virtual reality or augmented reality display, a vehicle, an automotive display, video walls comprising multiple displays tiled together, a theater or stadium screen, and a sign.

According to an embodiment, a device may include an organic light emitting device (OLED) having a substrate, a first electrode disposed over the substrate, a second electrode disposed over the first electrode, and an organic emissive layer disposed between the first electrode and the second electrode, where the organic emissive layer may have a first surface positioned over a second surface. A nanoparticle layer may be disposed over the organic emissive layer, where the nanoparticle layer may have a first surface that is positioned over a second surface. The nanoparticle layer may include a plurality of nanoparticles comprising a dielectric material, and a surrounding medium. The organic emissive layer may directly couple to the Mie scattering modes of the plurality of nanoparticles. A distance from the second surface of the nanoparticle layer to the first surface of the organic emissive layer may be not more than 1/5, not more than 1/8, and/or not more than 1/10 of a peak emission wavelength capable of being emitted by the organic emissive layer.

### BRIEF DESCRIPTION OF THE DRAWINGS

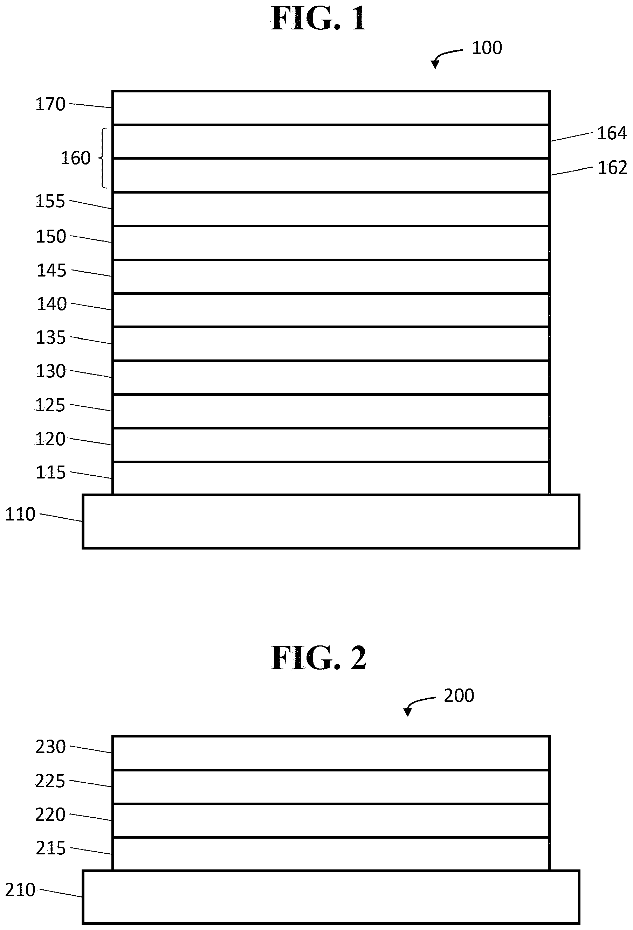

FIG. 1 shows an organic light emitting device.
FIG. 2 shows an inverted organic light emitting device that does not have a separate electron transport layer.

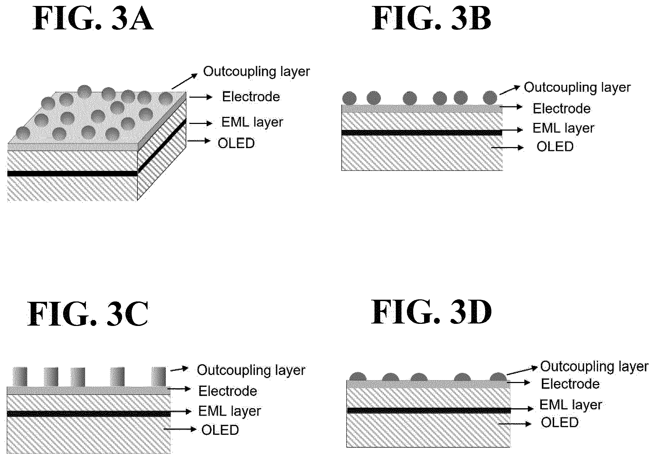

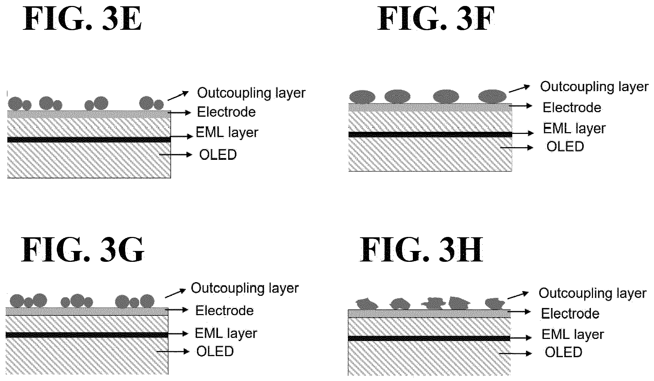

FIGS. 3A-3H show schematic representations of the proposed OLED design with transparent electrode and random arrays of spheres (FIGS. 3A-3B), cylinders (FIG. 3C), hemisphere (FIG. 3D), dimers of spheres (FIG. 3E), spheroids (FIG. 3F) trimers of spheres (FIG. 3G) and random (FIG. 3H) shaped dielectric particles as the outcoupling layer according to embodiments of the disclosed subject matter.

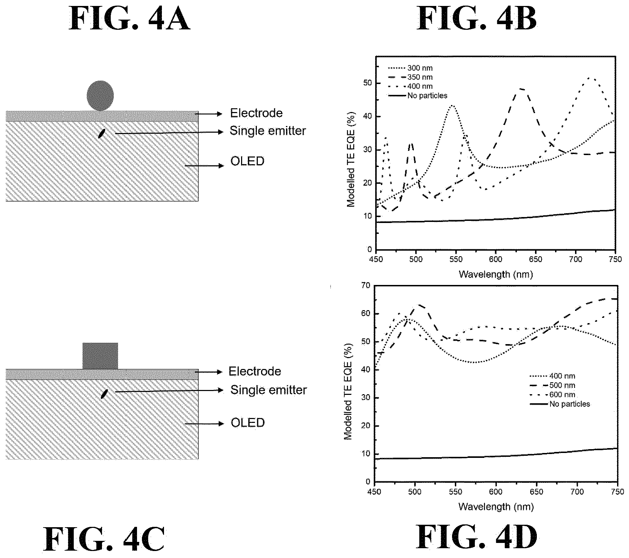

FIGS 4A and 4C show schematic representations of the OLED structure used in FDTD simulation showing a single isotropic dipole emitter and a dielectric sphere (FIG. 4A) and cylinder (FIG. 4C) of refractive index 2.5, above the transparent electrode, according to embodiments of the disclosed subject matter. In both of these simulations, the electrode is ITO (Indium Tin Oxide). FIG. 4B shows the simulated top emission (TE) EQE curves with a sphere of diameters 300 nm, 350 nm and 400 nm placed above the transparent electrode for the OLED design shown in FIG. 4A, according to an embodiment of the disclosed subject matter. FIG. 4D shows a simulated top emission (TE) EQE curves for the OLED device with a dielectric cylinder of diameters 400 nm, 500 nm, and 600 nm for the structure shown in FIG. 4C, according to embodiments of the disclosed subject matter. The solid curves in FIG. 4B and FIG. 4D represent the simulated TE EQE curves for the device without any dielectric particles, according to embodiments of the disclosed subject matter.

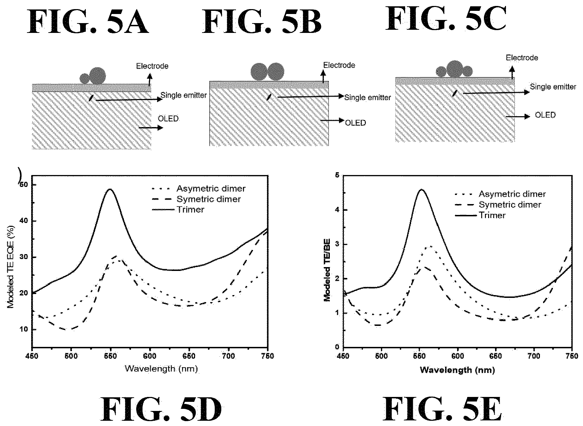

FIG. 5A shows a schematic representation of an OLED structure with an asymmetric dimer formed by spheres of diameter 300 nm and 200 nm according to an embodiment of the disclosed subject matter. FIG. 5B shows a symmetric dimer formed by two spheres of diameter 300 nm according to an embodiment of the disclosed subject matter. FIG. 5C shows a trimer formed a sphere of diameter 300 nm and two spheres of diameter 200 nm on transparent electrode for outcoupling according to an embodiment of the disclosed subject matter. FIGS. 5D-5E show the simulated TE EQE (FIG. 5D) and TE/BE (FIG. 5E) curves for the OLED structures shown in FIGS. 5A-5C according to embodiments of the disclosed subject matter.

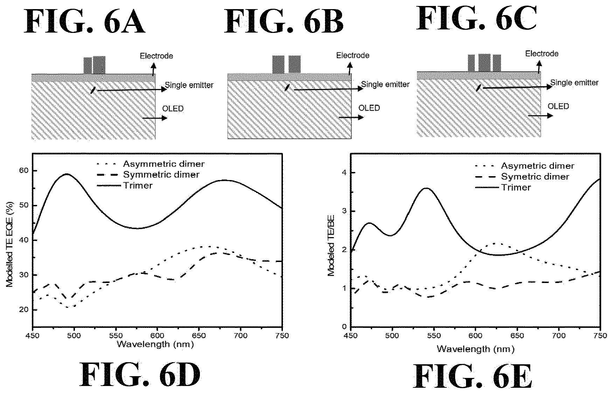

FIG. 6A shows a schematic representation of the OLED structure with an asymmetric dimer formed by cylinders of diameters 400 nm and 200 nm according to an embodiment of the disclosed subject matter. FIG. 6B shows a symmetric formed by cylinders of diameter 400 nm, and FIG. 6C shows a trimer formed by a cylinder of diameter 400 nm and two cylinders of diameter 200 nm on transparent electrode for outcoupling according to embodiments of the disclosed subject matter. The height of the cylinders shown in FIGS. 6A-6C is 100 nm, according to embodiments of the disclosed subject matter. FIGS. 6D-6E show the simulated TE EQE (FIG. 6D) and TE/BE (FIG. 6E) curves for the OLED structures shown in FIGS. 6A-6C according to embodiments of the disclosed subject matter.

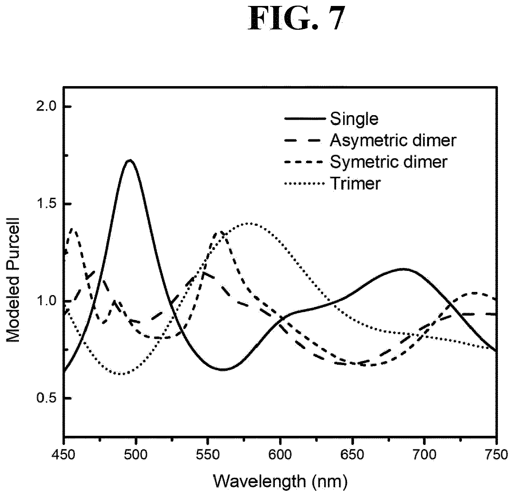

FIG. 7 shows estimated Purcell enhancement for a single isotropic emitter due to single cylinder of diameter 400 nm (solid curve), asymmetric dimer formed by cylinders of diameter 400 nm and 200 nm(dashed curve), symmetric dimer formed by cylinders of diameter 400nm (short dash) and trimer(dotted curve) formed by one cylinder of diameter 400 nm and two cylinders of diameters 200 nm, placed above the OLED device, according to embodiments of the disclosed subject matter.

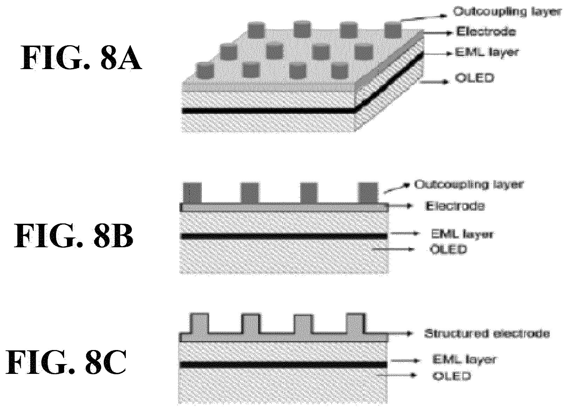

FIGS. 8A-8B show schematic representations of several embodiments with transparent electrode and a square array of dielectric cylinders as outcoupling layer according to embodiments of the disclosed subject matter. FIG. 8C shows a structured electrode as the electrode and the outcoupling layer, according to an embodiment of the disclosed subject matter.

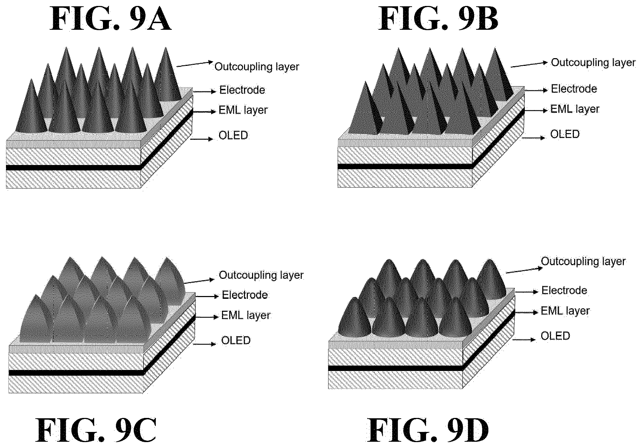

FIGS. 9A-9D show schematic representations of several embodiments with transparent electrode and a square array of dielectric particles with tapered end of shapes cones (FIG. 9A), square pyramid (FIG. 9B), particle with square base and curved edges (FIG. 9C) and parabolic cones (FIG. 9D) as the outcoupling layer according to an embodiment of the disclosed subject matter.

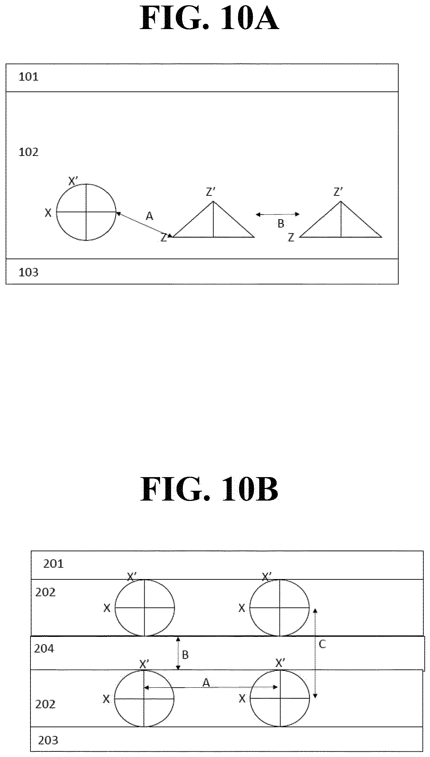

FIGS. 10A-10B show spacing arrangements of nanoparticles according to embodiments of the disclosed subject matter.

### DETAILED DESCRIPTION

Generally, an OLED comprises at least one organic layer disposed between and electrically connected to an anode and a cathode. When a current is applied, the anode injects holes and the cathode injects electrons into the organic layer(s). The injected holes and electrons each migrate toward the oppositely charged electrode. When an electron and hole localize on the same molecule, an "exciton," which is a localized electron-hole pair having an excited energy state, is formed. Light is emitted when the exciton relaxes via a photoemissive mechanism. In some cases, the exciton may be localized on an excimer or an exciplex. Non-radiative mechanisms, such as thermal relaxation, may also occur, but are generally considered undesirable.

The initial OLEDs used emissive molecules that emitted light from their singlet states ("fluorescence") as disclosed, for example, in U.S. Pat. No. 4,769,292, which is incorporated by reference in its entirety. Fluorescent emission generally occurs in a time frame of less than 10 nanoseconds.

More recently, OLEDs having emissive materials that emit light from triplet states ("phosphorescence") have been demonstrated. Baldo et al., "Highly Efficient Phosphorescent Emission from Organic Electroluminescent Devices," Nature, vol. 395, 151-154, 1998; ("Baldo-I") and Baldo et al., "Very high-efficiency green organic light-emitting devices based on electrophosphorescence," Appl. Phys. Lett., vol. 75, No. 3, 4-6 (1999) ("Baldo-II"), are incorporated by reference in their entireties. Phosphorescence is described in more detail in US Pat. No. 7,279,704 at cols. 5-6, which are incorporated by reference.

FIG. 1 shows an organic light emitting device 100. The figures are not necessarily drawn to scale. Device 100 may include a substrate 110, an anode 115, a hole injection layer 120, a hole transport layer 125, an electron blocking layer 130, an emissive layer 135, a hole blocking layer 140, an electron transport layer 145, an electron injection layer 150, a protective layer 155, a cathode 160, and a barrier layer 170. Cathode 160 is a compound cathode having a first conductive layer 162 and a second conductive layer 164. Device 100 may be fabricated by depositing the layers described, in order. The properties and functions of these various layers, as well as example materials, are described in more detail in US 7,279,704 at cols. 6-10, which are incorporated by reference.

More examples for each of these layers are available. For example, a flexible and transparent substrate-anode combination is disclosed in U.S. Pat. No. 5,844,363, which is incorporated by reference in its entirety. An example of a p-doped hole transport layer is m-MTDATA doped with F₄-TCNQ. at a molar ratio of 50:1, as disclosed in U.S. Patent Application Publication No. 2003/0230980, which is incorporated by reference in its entirety. Examples of emissive and host materials are disclosed in U.S. Pat. No. 6,303,238 to Thompson et al., which is incorporated by reference in its entirety. An example of an n-doped electron transport layer is Bphen doped with Li at a molar ratio of 1:1, as disclosed in U.S. Patent Application Publication No. 2003/0230980, which is incorporated by reference in its entirety. U.S. Pat. Nos. 5,703,436 and 5,707,745, which are incorporated by reference in their entireties, disclose examples of cathodes including compound cathodes having a thin layer of metal such as Mg:Ag with an overlying transparent, electrically-conductive, sputter-deposited ITO layer. The theory and use of blocking layers is described in more detail in U.S. Pat. No. 6,097,147 and U.S. Patent Application Publication No. 2003/0230980, which are incorporated by reference in their entireties. Examples of injection layers are provided in U.S. Patent Application Publication No. 2004/0174116, which is incorporated by reference in its entirety. Barrier layer 170 may be a single- or multi-layer barrier and may cover or surround the other layers of the device. The barrier layer 170 may also surround the substrate 110, and/or it may be arranged between the substrate and the other layers of the device. The barrier also may be referred to as an encapsulant, encapsulation layer, protective layer, or permeation barrier, and typically provides protection against permeation by moisture, ambient air, and other similar materials through to the other layers of the device. Examples of barrier layer materials and structures are provided in U.S. Patent Nos. 6,537,688, 6,597,111, 6,664,137, 6,835,950, 6,888,305, 6,888,307, 6,897,474, 7,187,119, and 7,683,534, each of which is incorporated by reference in its entirety.

FIG. 2 shows an inverted OLED 200. The device includes a substrate 210, a cathode 215, an emissive layer 220, a hole transport layer 225, and an anode 230. Device 200 may be fabricated by depositing the layers described, in order. Because the most common OLED configuration has a cathode disposed over the anode, and device 200 has cathode 215 disposed under anode 230, device 200 may be referred to as an "inverted" OLED. Materials similar to those described with respect to device 100 may be used in the corresponding layers of device 200. FIG. 2 provides one example of how some layers may be omitted from the structure of device 100.

The simple layered structure illustrated in FIGS. 1 and 2 is provided by way of non-limiting example, and it is understood that embodiments of the invention may be used in connection with a wide variety of other structures. The specific materials and structures described are exemplary in nature, and other materials and structures may be used. Functional OLEDs may be achieved by combining the various layers described in different ways, or layers may be omitted entirely, based on design, performance, and cost factors. Other layers not specifically described may also be included. Materials other than those specifically described may be used. Although many of the examples provided herein describe various layers as comprising a single material, it is understood that combinations of materials, such as a mixture of host and dopant, or more generally a mixture, may be used. Also, the layers may have various sublayers. The names given to the various layers herein are not intended to be strictly limiting. For example, in device 200, hole transport layer 225 transports holes and injects holes into emissive layer 220, and may be described as a hole transport layer or a hole injection layer. In one embodiment, an OLED may be described as having an "organic layer" disposed between a cathode and an anode. This organic layer may comprise a single layer, or may further comprise multiple layers of different organic materials as described, for example, with respect to FIGS. 1 and 2.

Structures and materials not specifically described may also be used, such as OLEDs comprised of polymeric materials (PLEDs) such as disclosed in U.S. Pat. No. 5,247,190 to Friend et al., which is incorporated by reference in its entirety. By way of further example, OLEDs having a single organic layer may be used. OLEDs may be stacked, for example as described in U.S. Pat. No. 5,707,745 to Forrest et al, which is incorporated by reference in its entirety. The OLED structure may deviate from the simple layered structure illustrated in FIGS. 1 and 2. For example, the substrate may include an angled reflective surface to improve out-coupling, such as a mesa structure as described in U.S. Pat. No. 6,091,195 to Forrest et al., and/or a pit structure as described in U.S. Pat. No. 5,834,893 to Bulovic et al., which are incorporated by reference in their entireties.

In some embodiments disclosed herein, emissive layers or materials, such as emissive layer 135 and emissive layer 220 shown in FIGS. 1-2, respectively, may include quantum dots. An "emissive layer" or "emissive material" as disclosed herein may include an organic emissive material and/or an emissive material that contains quantum dots or equivalent structures, unless indicated to the contrary explicitly or by context according to the understanding of one of skill in the art. In general, an emissive layer includes emissive material within a host matrix. Such an emissive layer may include only a quantum dot material which converts light emitted by a separate emissive material or other emitter, or it may also include the separate emissive material or other emitter, or it may emit light itself directly from the application of an electric current. Similarly, a color altering layer, color filter, upconversion, or downconversion layer or structure may include a material containing quantum dots, though such layer may not be considered an "emissive layer" as disclosed herein. In general, an "emissive layer" or material is one that emits an initial light based on an injected electrical charge, where the initial light may be altered by another layer such as a color filter or other color altering layer that does not itself emit an initial light within the device, but may re-emit altered light of a different spectra content based upon absorption of the initial light emitted by the emissive layer and downconversion to a lower energy light emission. In some embodiments disclosed herein, the color altering layer, color filter, upconversion, and/or downconversion layer may be disposed outside of an OLED device, such as above or below an electrode of the OLED device.

Unless otherwise specified, any of the layers of the various embodiments may be deposited by any suitable method. For the organic layers, preferred methods include thermal evaporation, ink-jet, such as described in U.S. Pat. Nos. 6,013,982 and 6,087,196, which are incorporated by reference in their entireties, organic vapor phase deposition (OVPD), such as described in U.S. Pat. No. 6,337,102 to Forrest et al., which is incorporated by reference in its entirety, and deposition by organic vapor jet printing (OVJP), such as described in U.S. Pat. No. 7,431,968, which is incorporated by reference in its entirety. Other suitable deposition methods include spin coating and other solution based processes. Solution based processes are preferably carried out in nitrogen or an inert atmosphere. For the other layers, preferred methods include thermal evaporation. Preferred patterning methods include deposition through a mask, cold welding such as described in U.S. Pat. Nos. 6,294,398 and 6,468,819, which are incorporated by reference in their entireties, and patterning associated with some of the deposition methods such as ink-jet and OVJD. Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons is a preferred range. Materials with asymmetric structures may have better solution processibility than those having symmetric structures, because asymmetric materials may have a lower tendency to recrystallize. Dendrimer substituents may be used to enhance the ability of small molecules to undergo solution processing.

Devices fabricated in accordance with embodiments of the present invention may further optionally comprise a barrier layer. One purpose of the barrier layer is to protect the electrodes and organic layers from damaging exposure to harmful species in the environment including moisture, vapor and/or gases, etc. The barrier layer may be deposited over, under or next to a substrate, an electrode, or over any other parts of a device including an edge. The barrier layer may comprise a single layer, or multiple layers. The barrier layer may be formed by various known chemical vapor deposition techniques and may include compositions having a single phase as well as compositions having multiple phases. Any suitable material or combination of materials may be used for the barrier layer. The barrier layer may incorporate an inorganic or an organic compound or both. The preferred barrier layer comprises a mixture of a polymeric material and a non-polymeric material as described in U.S. Pat. No. 7,968,146, PCT Pat. Application Nos. PCT/US2007/023098 and PCT/US2009/042829, which are herein incorporated by reference in their entireties. To be considered a "mixture", the aforesaid polymeric and non-polymeric materials comprising the barrier layer should be deposited under the same reaction conditions and/or at the same time. The weight ratio of polymeric to non-polymeric material may be in the range of 95:5 to 5:95. The polymeric material and the non-polymeric material may be created from the same precursor material. In one example, the mixture of a polymeric material and a non-polymeric material consists essentially of polymeric silicon and inorganic silicon.

In some embodiments, at least one of the anode, the cathode, or a new layer disposed over the organic emissive layer functions as an enhancement layer. The enhancement layer comprises a plasmonic material exhibiting surface plasmon resonance that non-radiatively couples to the emitter material and transfers excited state energy from the emitter material to non-radiative mode of surface plasmon polariton. The enhancement layer is provided no more than a threshold distance away from the organic emissive layer, wherein the emitter material has a total non-radiative decay rate constant and a total radiative decay rate constant due to the presence of the enhancement layer and the threshold distance is where the total non-radiative decay rate constant is equal to the total radiative decay rate constant. In some embodiments, the OLED further comprises an outcoupling layer. In some embodiments, the outcoupling layer is disposed over the enhancement layer on the opposite side of the organic emissive layer. In some embodiments, the outcoupling layer is disposed on opposite side of the emissive layer from the enhancement layer but still outcouples energy from the surface plasmon mode of the enhancement layer. The outcoupling layer scatters the energy from the surface plasmon polaritons. In some embodiments this energy is scattered as photons to free space. In other embodiments, the energy is scattered from the surface plasmon mode into other modes of the device such as but not limited to the organic waveguide mode, the substrate mode, or another waveguiding mode. If energy is scattered to the non-free space mode of the OLED other outcoupling schemes could be incorporated to extract that energy to free space. In some embodiments, one or more intervening layer can be disposed between the enhancement layer and the outcoupling layer. The examples for intervening layer(s) can be dielectric materials, including organic, inorganic, perovskites, oxides, and may include stacks and/or mixtures of these materials.

The enhancement layer modifies the effective properties of the medium in which the emitter material resides resulting in any or all of the following: a decreased rate of emission, a modification of emission line-shape, a change in emission intensity with angle, a change in the stability of the emitter material, a change in the efficiency of the OLED, and reduced efficiency roll-off of the OLED device. Placement of the enhancement layer on the cathode side, anode side, or on both sides results in OLED devices which take advantage of any of the above-mentioned effects. In addition to the specific functional layers mentioned herein and illustrated in the various OLED examples shown in the figures, the OLEDs according to the present disclosure may include any of the other functional layers often found in OLEDs.

The enhancement layer can be comprised of plasmonic materials, optically active metamaterials, or hyperbolic metamaterials. As used herein, a plasmonic material is a material in which the real part of the dielectric constant crosses zero in the visible or ultraviolet region of the electromagnetic spectrum. In some embodiments, the plasmonic material includes at least one metal. In such embodiments the metal may include at least one of Ag, Al, Au, Ir, Pt, Ni, Cu, W, Ta, Fe, Cr, Mg, Ga, Rh, Ti, Ru, Pd, In, Bi, Ca alloys or mixtures of these materials, and stacks of these materials. In general, a metamaterial is a medium composed of different materials where the medium as a whole acts differently than the sum of its material parts. In particular, we define optically active metamaterials as materials which have both negative permittivity and negative permeability. Hyperbolic metamaterials, on the other hand, are anisotropic media in which the permittivity or permeability are of different sign for different spatial directions. Optically active metamaterials and hyperbolic metamaterials are strictly distinguished from many other photonic structures such as Distributed Bragg Reflectors ("DBRs") in that the medium should appear uniform in the direction of propagation on the length scale of the wavelength of light. Using terminology that one skilled in the art can understand: the dielectric constant of the metamaterials in the direction of propagation can be described with the effective medium approximation. Plasmonic materials and metamaterials provide methods for controlling the propagation of light that can enhance OLED performance in a number of ways.

In some embodiments, the enhancement layer is provided as a planar layer. In other embodiments, the enhancement layer has wavelength-sized features that are arranged periodically, quasi-periodically, or randomly, or sub-wavelength-sized features that are arranged periodically, quasi-periodically, or randomly. In some embodiments, the wavelength-sized features and the sub-wavelength-sized features have sharp edges.

In some embodiments, the outcoupling layer has wavelength-sized features that are arranged periodically, quasi-periodically, or randomly, or sub-wavelength-sized features that are arranged periodically, quasi-periodically, or randomly. In some embodiments, the outcoupling layer may be composed of a first plurality of nanoparticles and in other embodiments the outcoupling layer is composed of a plurality of nanoparticles disposed over a material. In these embodiments the outcoupling may be tunable by at least one of varying a size of the first plurality of nanoparticles, varying a shape of the first plurality of nanoparticles, changing a material of the first plurality of nanoparticles, adjusting a thickness of the material, changing the refractive index of the material or an additional layer disposed on the first plurality of nanoparticles, varying a thickness of the enhancement layer, and/or varying the material of the enhancement layer. The first plurality of nanoparticles of the device may be formed from at least one of metal, dielectric material, semiconductor materials, an alloy of metal, a mixture of dielectric materials, a stack or layering of one or more materials, and/or a core of one type of material and that is coated with a shell of a different type of material. In some embodiments, the outcoupling layer is composed of at least metal nanoparticles wherein the metal is selected from the group consisting of Ag, Al, Au, Ir, Pt, Ni, Cu, W, Ta, Fe, Cr, Mg, Ga, Rh, Ti, Ru, Pd, In, Bi, Ca, alloys or mixtures of these materials, and stacks of these materials. The first plurality of nanoparticles may have additional layer disposed over them. In some embodiments, the polarization of the emission can be tuned using the outcoupling layer. Varying the dimensionality and periodicity of the outcoupling layer can select a type of polarization that is preferentially outcoupled to air. In some embodiments the outcoupling layer also acts as an electrode of the device.

It is believed that the internal quantum efficiency (IQE) of fluorescent OLEDs can exceed the 25% spin statistics limit through delayed fluorescence. As used herein, there are two types of delayed fluorescence, i.e., P-type delayed fluorescence and E-type delayed fluorescence. P-type delayed fluorescence is generated from triplet-triplet annihilation (TTA).

On the other hand, E-type delayed fluorescence does not rely on the collision of two triplets, but rather on the thermal population between the triplet states and the singlet excited states. Compounds that are capable of generating E-type delayed fluorescence are required to have very small singlet-triplet gaps. Thermal energy can activate the transition from the triplet state back to the singlet state. This type of delayed fluorescence is also known as thermally activated delayed fluorescence (TADF). A distinctive feature of TADF is that the delayed component increases as temperature rises due to the increased thermal energy. If the reverse intersystem crossing rate is fast enough to minimize the non-radiative decay from the triplet state, the fraction of back populated singlet excited states can potentially reach 75%. The total singlet fraction can be 100%, far exceeding the spin statistics limit for electrically generated excitons.

E-type delayed fluorescence characteristics can be found in an exciplex system or in a single compound. Without being bound by theory, it is believed that E-type delayed fluorescence requires the luminescent material to have a small singlet-triplet energy gap (ΔES-T). Organic, non-metal containing, donor-acceptor luminescent materials may be able to achieve this. The emission in these materials is often characterized as a donor-acceptor charge-transfer (CT) type emission. The spatial separation of the HOMO and LUMO in these donor-acceptor type compounds often results in small ΔES-T. These states may involve CT states. Often, donor-acceptor luminescent materials are constructed by connecting an electron donor moiety such as amino- or carbazole-derivatives and an electron acceptor moiety such as N-containing six-membered aromatic ring.

Devices fabricated in accordance with embodiments of the invention can be incorporated into a wide variety of electronic component modules (or units) that can be incorporated into a variety of electronic products or intermediate components. Examples of such electronic products or intermediate components include display screens, lighting devices such as discrete light source devices or lighting panels, etc. that can be utilized by the end-user product manufacturers. Such electronic component modules can optionally include the driving electronics and/or power source(s). Devices fabricated in accordance with embodiments of the invention can be incorporated into a wide variety of consumer products that have one or more of the electronic component modules (or units) incorporated therein. A consumer product comprising an OLED that includes the compound of the present disclosure in the organic layer in the OLED is disclosed. Such consumer products would include any kind of products that include one or more light source(s) and/or one or more of some type of visual displays. Some examples of such consumer products include a flat panel display, a curved display, a computer monitor, a medical monitor, a television, a billboard, a light for interior or exterior illumination and/or signaling, a heads-up display, a fully or partially transparent display, a flexible display, a rollable display, a foldable display, a stretchable display, a laser printer, a telephone, a cell phone, tablet, a phablet, a personal digital assistant (PDA), a wearable device, a laptop computer, a digital camera, a camcorder, a viewfinder, a micro-display that is less than 2 inches diagonal, a 3-D display, a virtual reality or augmented reality display, a vehicle, an automotive display, video walls comprising multiple displays tiled together, a theater or stadium screen, and a sign. Various control mechanisms may be used to control devices fabricated in accordance with the present invention, including passive matrix and active matrix. Many of the devices are intended for use in a temperature range comfortable to humans, such as 18 C to 30 C, and more preferably at room temperature (20-25 C), but could be used outside this temperature range, for example, from -40 C to 80 C.

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

In some embodiments, the OLED has one or more characteristics selected from the group consisting of being flexible, being rollable, being foldable, being stretchable, and being curved. In some embodiments, the OLED is transparent or semi-transparent. In some embodiments, the OLED further comprises a layer comprising carbon nanotubes.

In some embodiments, the OLED further comprises a layer comprising a delayed fluorescent emitter. In some embodiments, the OLED comprises a RGB pixel arrangement or white plus color filter pixel arrangement. In some embodiments, the OLED is a mobile device, a hand held device, or a wearable device. In some embodiments, the OLED is a display panel having less than 10 inch diagonal or 50 square inch area. In some embodiments, the OLED is a display panel having at least 10 inch diagonal or 50 square inch area. In some embodiments, the OLED is a lighting panel.

In some embodiments of the emissive region, the emissive region further comprises a host.

In some embodiments, the compound can be an emissive dopant. In some embodiments, the compound can produce emissions via phosphorescence, fluorescence, thermally activated delayed fluorescence, i.e., TADF (also referred to as E-type delayed fluorescence), triplet-triplet annihilation, or combinations of these processes.

The OLED disclosed herein can be incorporated into one or more of a consumer product, an electronic component module, and a lighting panel. The organic layer can be an emissive layer and the compound can be an emissive dopant in some embodiments, while the compound can be a non-emissive dopant in other embodiments.

The organic layer can also include a host. In some embodiments, two or more hosts are preferred. In some embodiments, the hosts used maybe a) bipolar, b) electron transporting, c) hole transporting or d) wide band gap materials that play little role in charge transport. In some embodiments, the host can include a metal complex. The host can be an inorganic compound.

### COMBINATION WITH OTHER MATERIALS

The materials described herein as useful for a particular layer in an organic light emitting device may be used in combination with a wide variety of other materials present in the device. For example, emissive dopants disclosed herein may be used in conjunction with a wide variety of hosts, transport layers, blocking layers, injection layers, electrodes and other layers that may be present. The materials described or referred to below are non-limiting examples of materials that may be useful in combination with the compounds disclosed herein, and one of skill in the art can readily consult the literature to identify other materials that may be useful in combination.

Various materials may be used for the various emissive and non-emissive layers and arrangements disclosed herein. Examples of suitable materials are disclosed in U.S. Patent Application Publication No. 2017/0229663, which is incorporated by reference in its entirety.

### Conductivity Dopants:

A charge transport layer can be doped with conductivity dopants to substantially alter its density of charge carriers, which will in turn alter its conductivity. The conductivity is increased by generating charge carriers in the matrix material, and depending on the type of dopant, a change in the Fermi level of the semiconductor may also be achieved. Hole-transporting layer can be doped by p-type conductivity dopants and n-type conductivity dopants are used in the electron-transporting layer.

### HIL/HTL:

A hole injecting/transporting material to be used in the present invention is not particularly limited, and any compound may be used as long as the compound is typically used as a hole injecting/transporting material.

### EBL:

An electron blocking layer (EBL) may be used to reduce the number of electrons and/or excitons that leave the emissive layer. The presence of such a blocking layer in a device may result in substantially higher efficiencies, and or longer lifetime, as compared to a similar device lacking a blocking layer. Also, a blocking layer may be used to confine emission to a desired region of an OLED. In some embodiments, the EBL material has a higher LUMO (closer to the vacuum level) and/or higher triplet energy than the emitter closest to the EBL interface. In some embodiments, the EBL material has a higher LUMO (closer to the vacuum level) and or higher triplet energy than one or more of the hosts closest to the EBL interface. In one aspect, the compound used in EBL contains the same molecule or the same functional groups used as one of the hosts described below.

### Host:

The light emitting layer of the organic EL device of the present invention preferably contains at least a metal complex as light emitting material, and may contain a host material using the metal complex as a dopant material. Examples of the host material are not particularly limited, and any metal complexes or organic compounds may be used as long as the triplet energy of the host is larger than that of the dopant. Any host material may be used with any dopant so long as the triplet criteria is satisfied.

### EML:

EML can comprise a phosphorescent or fluorescent emitter. Phosphorescence generally refers to emission of a photon with a change in electron spin, i.e., the initial and final states of the emission have different multiplicity, such as from T1 to S0 state. Ir and Pt complexes currently widely used in the OLED belong to phosphorescent emitters. In some embodiments, if an exciplex formation involves a triplet emitter, such exciplex can also emit phosphorescent light. On the other hand, fluorescent emitters generally refer to emission of a photon without a change in electron spin, such as from S1 to S0 state. Fluorescent emitters can be delayed fluorescent or non-delayed fluorescent emitters. Depending on the spin state, fluorescent emitter can be a singlet emitter or a doublet emitter, or other multiplet emitter. It is believed that the internal quantum efficiency (IQE) of fluorescent OLEDs can exceed the 25% spin statistics limit through delayed fluorescence. There are two types of delayed fluorescence, i.e., P-type and E-type delayed fluorescence. P-type delayed fluorescence is generated from triplet-triplet annihilation (TTA). On the other hand, E-type delayed fluorescence does not rely on the collision of two triplets, but rather on the thermal population between the triplet states and the singlet excited states. Thermal energy can activate the transition from the triplet state back to the singlet state. This type of delayed fluorescence is also known as thermally activated delayed fluorescence (TADF). E-type delayed fluorescence characteristics can be found in an exciplex system or in a single compound. Without being bound by theory, it is believed that TADF requires a compound or an exciplex having a small singlet-triplet energy gap (ΔES-T) less than or equal to 300, 250, 200, 150, 100, or 50 meV. There are two major types of TADF emitters, one is called donor-acceptor type TADF, the other one is called multiple resonance (MR) TADF. Often, donor-acceptor single compounds are constructed by connecting an electron donor moiety such as amino- or carbazole-derivatives and an electron acceptor moiety such as N-containing six-membered aromatic ring. Donor-acceptor exciplex can be formed between a hole transporting compound and an electron transporting compound. The examples for MR-TADF include a highly conjugated boron-containing compounds. In some embodiments, the reverse intersystem crossing time from T1 to S1 of the delayed fluorescent emission at 293K is less than or equal to 10 microseconds. In some embodiments, such time can be greater than 10 microseconds and less than 100 microseconds.

In some embodiments, the emissive dopant can be a phosphorescent or fluorescent material. In some embodiments, the non-emissive dopant can also be a phosphorescent or fluorescent material. In some embodiments, the OLED may comprise an additional compound selected from the group consisting of a fluorescence material, a delayed fluorescence material, a phosphorescent material, and combination thereof.

In some embodiments, the phosphorescent material is an emitter which emits light within the OLED. In some embodiments, the phosphorescent material does not emit light within the OLED. In some embodiments, the phosphorescent material energy transfers its excited state to another material within the OLED. In some embodiments, the phosphorescent material participates in charge transport within the OLED. In some embodiments, the phosphorescent material is a sensitizer, and the OLED further comprises an acceptor. In some embodiments, the phosphorescent emitter and the acceptor both emit light within the OLED.

In some embodiments, the fluorescence material or the delayed fluorescence material is an emitter which emits light within the OLED. In some embodiments, the fluorescence material or the delayed fluorescence material does not emit light within the OLED. In some embodiments, the fluorescence material or the delayed fluorescence material energy transfers its excited state to another material within the OLED. In some embodiments, the fluorescence material or the delayed fluorescence material participates in charge transport within the OLED. In some embodiments, the fluorescence material or the delayed fluorescence material is a sensitizer, and the OLED further comprises an acceptor.

### HBL:

A hole blocking layer (HBL) may be used to reduce the number of holes and/or excitons that leave the emissive layer. The presence of such a blocking layer in a device may result in substantially higher efficiencies and/or longer lifetime as compared to a similar device lacking a blocking layer. Also, a blocking layer may be used to confine emission to a desired region of an OLED. In some embodiments, the HBL material has a lower HOMO (further from the vacuum level) and or higher triplet energy than the emitter closest to the HBL interface. In some embodiments, the HBL material has a lower HOMO (further from the vacuum level) and or higher triplet energy than one or more of the hosts closest to the HBL interface.

### ETL:

An electron transport layer (ETL) may include a material capable of transporting electrons. The electron transport layer may be intrinsic (undoped), or doped. Doping may be used to enhance conductivity. Examples of the ETL material are not particularly limited, and any metal complexes or organic compounds may be used as long as they are typically used to transport electrons.

### Charge generation layer (CGL)

In tandem or stacked OLEDs, the CGL plays an essential role in the performance, which is composed of an n-doped layer and a p-doped layer for injection of electrons and holes, respectively. Electrons and holes are supplied from the CGL and electrodes. The consumed electrons and holes in the CGL are refilled by the electrons and holes injected from the cathode and anode, respectively; then, the bipolar currents reach a steady state gradually. Typical CGL materials include n and p conductivity dopants used in the transport layers.

Organic light emitting devices (OLEDs) are becoming widely adopted in display and other light-generating applications. However, the devices fundamentally face several challenges, including maximizing the number of photons that are coupled into free space, and enhancing stability and efficiency for light emitting devices, particularly blue light emitting devices. Typical OLED device, that are top or bottom emitting, utilize at least one electrode that also functions as a mirror. This electrode reflects light so that the device emits only from a single side, maximizing the efficiency of light that can be collected. However, since the electrode is metallic, the emitters in the emissive layer of the OLED can couple to the electrode and generate surface plasmons. These surface plasmons have a large in-plane momentum and cannot be directly recovered to photons in free space, leading to a lowering of the efficiency of the OLED. Embodiments of the disclosed subject matter may include low-loss OLEDs which utilize the Mie scattering of nanoparticles to outcouple the light and nonmetallic electrodes to avoid the losses associated with metallic electrodes. In some embodiments, these devices have increased efficiency over that of typical devices which have a metal-based electrode. In some embodiments, the overall efficiency of the device may be similar or lower than metal-based OLEDs, but angular dependence and/or emission shape may be improved when compared to OLEDs containing a metal electrode.

Embodiments of the disclosed subject matter provide low-loss OLEDs, which utilizes high-refractive index dielectric particles to outcouple the EL (electroluminescence) emission from the OLEDs. The low-loss OLEDs may provide enhanced external quantum efficiency (EQE) for both horizontal and vertical aligned dipoles. In some embodiments, the OLEDs may have minimal Purcell enhancement. However, the device may be driven at lower current and thereby increase the overall device stability even without a Purcell enhancement. In some embodiments, to reduce the ohmic loses due to metal electrodes, non-metallic electrodes or multilayer stack with thin layers of metallic and nonmetallic conducting layers may be used for the electrodes. An array of high-index, low loss dielectric particles disposed on one or both transparent conducting electrodes may be used to outcouple the emissive layer of the OLED from the device.

In some embodiments, the electrodes may be a thin layer of indium tin oxide (ITO), fluorine doped tin oxide (FTO), indium doped zinc oxide (IZO), Aluminum Zinc Oxide (AZO), indium-doped cadmium oxide, barium stannate, carbon nanotubes, graphene, multilayer graphene, single layer graphene, graphene oxide, metallic nano particle or nanowire impregnated materials, as well as conductive polymers such as polyacetylene, polypyrrole, polyindole, polyaniline, Poly(p-phenylene vinylene), poly(3-alkylthiophenes), (poly(3,4-ethylenedioxythiophene)), and the like.

In some embodiments, a composite material that may include one or more polymers, oxide materials, carbon-based compounds, and the like with nano-sized metallic particles or nano wires may be used as the electrode. In some embodiments, the electrodes may include a plurality of layers of conducting materials (e.g., such as those described above), or without a thin metallic layer. In some embodiments, when a metallic layer is used in the electrode the EML layer will be placed at least 75 nm away from the metal layer to minimize the plasmon loss owing to the excitation of plasmon modes. In some embodiments, the thickness of the metallic layer may be at least 2 nm but not more than 10 nm to ensure light transmission through the electrode. The total thickness of the transparent conducting electrode may be between 10 to 200 nm, and more preferably between 30nm to less than 50 nm.

FIGS. 10A-10B show spacing arrangements of nanoparticles according to embodiments of the disclosed subject matter. As shown in FIGS. 10A-10B, layer(s) 102, 202 may be the nanoparticle layer, which may be part of the outcoupling layer shown in FIGS. 3A-3H and/or FIGS. 9A-9D and described in detail below, and/or may be part of the nanoparticle layers shown in FIGS. 4A, 4C, 5A-5C, and/or 6A-6C as described in detail below. Layer(s) 101, 201 may be any number of layers disposed above the nanoparticle layer. Layer(s) 103, 203 are any number of layers disposed below the nanoparticle layer.

As used throughout, "in-plane" may be defined as a plane "horizontal" to the substrate, and/or any other layer that is disposed horizontally on the substrate. As used throughout, "out-of-plane" may be defined as a plane "perpendicular" to the substrate, and/or any other layer that is disposed horizontally on the substrate.

In an embodiment where there is an array in the vertical direction, there may be a dielectric layer between multiple nanoparticle layers. The dielectric layer may not be needed in the arrangement shown in FIG. 10A, and therefore is not shown in FIG. 10A. However, the embodiment shown in FIG. 10B may include dielectric layer 204. In an alternative embodiment, there may be no dielectric layer between the stacked array of nanoparticle layers, and the nanoparticles may sit almost directly on top of a nanoparticle layer below.

In an embodiment, the bottom of the nanoparticle layer to the top of the emissive layer is not more than 50 nm. In an embodiment, this 50 nm distance may include a dielectric gap directly underneath the nanoparticle layer. In an embodiment, nanoparticles in the nanoparticle layer may sit almost directly on top of the layer below the nanoparticle layer, for example on top of an emissive layer. In an embodiment, nanoparticle in the nanoparticle layer may sit on top of a dielectric gap, as noted above.

FIG. 10A shows random placement of nanoparticles according to embodiments of the disclosed subject matter. Each nanoparticle may be at least 100 nm, at least 200 nm, at least 300 nm, and/or at least 500 nm in distance for the largest in-plane direction. In FIG. 10A, this may be the X and both Z distances. Additionally, the in-plane direction may run into and out of the paper (i.e., the third dimension not shown in the two-dimensional drawing of FIG. 10A).

Each nanoparticle may be at least 50 nm, at least 150 nm, at least 300 nm, and/or at least 500 nm in distance for the largest out-of-plane direction. As shown in FIG. 10A, this may be in the X' and both Z' distances.

In a first embodiment, the shortest edge-to-edge spacing may be a horizontal in-plane distance between to any adjacent nanoparticle. In the first embodiment, this distance (i.e., distance B as shown in FIG. 10A) may be less than 100 nm, less than 50 nm, less than 25 nm, and/or may be less than 10 nm.

In a second embodiment, the shortest edge-to-edge spacing may be a distance to any adjacent nanoparticle in any plane. In the second embodiment, this distance (i.e., distance A as shown in FIG. 10 A) may be less than 100 nm, less than 50 nm, less than 25 nm, and/or may be less than 10 nm.

FIG. 10B shows an array placement of nanoparticles according to embodiments of the disclosed subject matter. Each nanoparticle may be at least 100 nm, at least 200 nm, at least 300 nm, and/or at least 500 nm in distance for the largest in-plane direction. As shown in FIG. 10B, this may be the X distances for each circle.

Each nanoparticle may be at least 50 nm, at least 150 nm, at least 300 nm, and/or at least 500 nm in distance for the largest out-of-plane direction. As shown in FIG. 10B, this may be the X' distances for each circle.

A center-to-center interparticle spacing of the first plurality of nanoparticles in any ordered direction may be less than 300 nm, less than 400 nm, less than 500 nm, and/or less than 600 nm. As shown in FIG. 10B, this may be the A distance and is a direction parallel to the substrate. Similar to above, it should be noted that center-to-center interparticle spacing also runs into and out of the paper (i.e., the third dimension not shown in this two-dimensional drawing of FIG. 10B).

When nanoparticles are manufactured, it is well known and understood that each nanoparticle is not identical and there are manufacturing variances between individual nanoparticles. For example, nanoparticle spheres may be produced that have an average diameter of 100nm with a standard deviation ±5nm. In this example, the coefficient of variation is 5%. In another example, nanoparticle cubes may be produced that an average length of each side of 100nm with a standard deviation of ±5nm. In this example, the coefficient of variation is 5%. In an embodiment, any distance of a nanoparticle may be used to define the nanoparticle. For example, radius or diameter of a sphere, height of a cone, side of a cube, length of a rectangle, width of a rectangle, and the like.

In an embodiment, a first nanoparticle is sized differently from a second nanoparticle when the average size of the first particle is different than one standard deviation of the average size of the second particle. In an alternative embodiment, a first nanoparticle is sized differently from a second nanoparticle when the average size of the first particle is different than two standard deviation of the average size of the second particle. In yet another alternative embodiment, a first nanoparticle is sized differently from a second nanoparticle when the average size of the first particle is different than any number of standard deviation of the average size of the second particle.

In an embodiment, a first nanoparticle is sized differently from a second nanoparticle when the average size of the first particle is different than one coefficient of variation of the average size of the second particle. In an alternative embodiment, a first nanoparticle is sized differently from a second nanoparticle when the average size of the first particle is different than two coefficient of variation of the average size of the second particle. In yet another alternative embodiment, a first nanoparticle is sized differently from a second nanoparticle when the average size of the first particle is different than any number of coefficient of variation of the average size of the second particle.

Similarly, when nanoparticles are manufactured, it is well known and understood that each nanoparticle shape is not identical and there are manufacturing variances between individual nanoparticles. Therefore, while all nanoparticles may be a sphere, for example, they are not all identical spheres, and there may be a difference sphericity between one or more of the nanoparticles. Similarly, while all nanoparticles may be a cone, for example, they are not all identical cones, and there may be a different conicity between one or more conical nanoparticles. There may be one or remnant and/or waste particles that may be distributed amongst a layer of nanoparticles that result from the forming of the nanoparticles. For example, there may be remnant and/or waste particles that are differently sized and/or shaped that are distributed amongs a layer, matrix, and/or other arrangement of spherical nanoparticles. In an embodiment, a first nanoparticle is a different shape nanoparticle than a second nanoparticle when the devices disclosed herein perform differently utilizing the first nanoparticle versus the second nanoparticle.

In an embodiment, the layers may be stacked so at least a portion of a nanoparticle in the top layer is above a corresponding nanoparticle in the bottom layer. In an embodiment, the layers may be stacked so the nanoparticle in the top layer is offset from a corresponding nanoparticle in the bottom layer (i.e., having no overlap).

FIGS. 3A-3H schematically illustrates several embodiments of the OLED design of the disclosed subject matter using a random array of dielectric particles as the outcoupling layer. FIGS. 3A-3B show random arrays of spheres, FIG. 3C shows cylinders, FIG. 3D shows hemispheres, FIG. 3E shows dimers of spheres, FIG. 3F shows spheroids, FIG. 3G shows trimers of spheres, and FIG. 3H shows shaped dielectric particles as the outcoupling layer according to embodiments of the disclosed subject matter.

The EQE enhancement may depend on the scattering efficiency of the dielectric particles. Unlike the metal particles, where the excitations are mostly electric resonances, the dielectric particles may excite both electric and magnetic mode resonances. This may provide efficient control over the light scattering, and may optimize the intensity in a forward or backward direction, and/or in steering the beam in arbitrary direction. Since the radiation of the dipole emitters may be affected by the surrounding medium, an enhancement in the Purcell factor may be expected with the dielectric nanoparticle as the outcoupling layer.

The scattering efficiency of the dielectric particles may depend on the particle size, shape, and/or the material refractive index. For particle size comparable to the wavelength of the light, the scattering efficiency may be estimated based on Mie's theory. The enhanced light outcoupling may be achieved by direct coupling of EL emission (i.e., emission by the emissive layer (EL)) to the Mie scattering modes of the nanoparticles. To enable strong coupling of EL emission to the Mie scattering modes of the nanoparticles, the EML layer may be disposed closer to the outcoupling layer such that distance from the top of the EML layer to the bottom of the outcoupling layer is within 1/10 of the peak emission wavelength of the emitter. In some embodiments, coupling between the Mie scattering modes and at least some of the EML layer may occur at longer distances, up to 1/2 of the peak emission wavelength of the emitter. One difference between at least some embodiments of the disclosed subject matter and other OLEDs containing dielectric nanoparticles is the direct coupling of the emitters in the EML to the Mie modes of the dielectric particles. In OLEDs using dielectric nanoparticles without direct coupling to the Mie modes, the emitter first generates or emits a photon which later is scattered by the Mie modes of the dielectric nanoparticles. Conversely, in embodiments of the disclosed subject matter, the emission event of the photon from the emitter involves the Mie mode of the particles directly. For this reason, proximity between the EML and the dielectric nanoparticles is preferred. Since the scattering efficiency increases with refractive index, materials with high index of refraction are preferred. Additionally, materials with lower light absorption in the visible region may be used. Some high index materials, which may be used for preparing the nano-sized particles may include silicon, silicon nitride, boron nitride, silicon carbide, carbon, diamond, zinc sulfide, zinc selenide, germanium, zinc telluride, potassium niobate, titanium oxide, antimony oxide, niobium pentoxide, tantalum pentoxide, vanadium oxide, vanadium pentoxide, gallium phosphate, bismuth oxide, gallium arsenide, and/or aluminum gallium.

Arbitrary-shaped particles with preferred spectral characteristics in single or multiparticle configurations such as dimers, trimers, and the like as shown in FIGS. 3A-3H, may be used to control the scattering wavelength and efficiency of the outcoupling layer. In some embodiments, the dielectric particle may be made with two or more materials having a different refractive index, homogenously or inhomogeneously distributed within the structures, where at least one of the two or more materials creates the difference of at least 1.0 between the refractive index of the at least one of the two or more materials and the surrounding medium.

To demonstrate the enhancement in the outcoupling efficiency of the proposed low-loss OLEDs, the EQEs of OLED devices were simulated using single or multiple dielectric particles of different shapes and sizes for outcoupling. The simulations were performed by finite difference time domain (FDTD) method using Ansys Lumerical^{™} FDTD solutions. Different layers of the OLED devices were rendered into a computational volume of 4 µm ×4 µm ×1 µm by their refractive index values and were enclosed within the perfectly matched layers (PML) in all directions to match the open boundary conditions. A single dipole emitter in vertical or horizonal orientation with broad emission spectrum covering the entire visible region (450 - 750 nm), placed 20 nm away from a 50 nm thick ITO electrode that acts as the emissive layer. That is, the simulations were performed with a 70 nm distance between the emissive layer and the nanoparticles. We used a 75 nm thick non absorbing dielectric layer with refractive index of 1.7 to model the host medium. The simulations were performed with and without high index particles above the ITO layer. The light emission in the far field were recorded using two power monitors placed 300 nm above the particle and 250 nm below the bottom of the OLED stack, which were used to calculate the top emission (TE) and bottom emission (BE) EQEs of the device respectively. The computational volume was discretized with a non-uniform index adjusted rectangular mesh with a resolution of 34 mesh cells per wavelength. Additionally, a mesh override region with 1 nm resolution was used for high index dielectric particles to minimize the computational error. The Purcell enhancement was estimated by calculating the power emitter by the dipole using a box of monitors surrounding the emitter normalized to the free space emission power.

FIGS. 4A and 4C show schematic representations of the OLED structure used in FDTD simulation showing a single isotropic dipole emitter and a dielectric sphere (FIG. 4A) and cylinder (FIG. 4C) of refractive index 2.5, above the transparent electrode, according to embodiments of the disclosed subject matter. The outcoupling shown in FIGS. 4A and 4C demonstrate the spectral tunability with size and shape of the dielectric particles. In both of these simulations, the electrode is ITO. FIG. 4B shows the simulated top emission (TE) EQE curves with a sphere of diameters 300 nm, 350 nm and 400 nm placed above the transparent electrode for the OLED design shown in FIG. 4A, according to an embodiment of the disclosed subject matter. FIG. 4D shows a simulated top emission (TE) EQE curves for the OLED device with a dielectric cylinder of diameters 400 nm, 500 nm, and 600 nm for the structure shown in FIG. 4C, according to embodiments of the disclosed subject matter. The solid curves in FIG. 4B and FIG. 4D represent the simulated TE EQE curves for the device without any dielectric particles, according to embodiments of the disclosed subject matter. Enhanced EQE values compared to the OLED device without any dielectric particle are evident. The particles located above the transparent electrode enable outcoupling of the light to the far field by light scattering while minimizing the waveguiding effect in the OLED stack resulting in enhanced EQE.

Additionally, the scattering properties can be further modified by assembling multiple particles in the form of dimers, trimers etc. as illustrated in FIGS. 5A-5E and FIGS. 6A-6E. The particle assemblies can be tuned to achieve directional emission from the OLED device.

FIG. 5A shows a schematic representation of an OLED structure with an asymmetric dimer formed by spheres of diameter 300 nm and 200 nm according to an embodiment of the disclosed subject matter. FIG. 5B shows a symmetric dimer formed by two spheres of diameter 300 nm according to an embodiment of the disclosed subject matter. FIG. 5C shows a trimer formed a sphere of diameter 300 nm and two spheres of diameter 200 nm on transparent electrode for outcoupling according to an embodiment of the disclosed subject matter. FIGS. 5D-5E show the simulated TE EQE (FIG. 5D) and TE/BE (FIG. 5E) curves for the OLED structures shown in FIGS. 5A-5C according to embodiments of the disclosed subject matter.

That is, the plots in FIGS. 5D-5E show the simulated TE EQE and TE/BE curves for an OLED device with an asymmetric dimer formed by spheres of different sizes (dotted curve), symmetric dimer (dashed curve) formed by spheres of same size and trimer assembly formed by one large sphere and two smaller spheres of same size (solid curve) indicating enhanced TE EQE. Furthermore, TE/BE curves shown FIG. 5E indicate that the emission from these devices are predominantly directed towards top side of the device.

FIG. 6A shows a schematic representation of the OLED structure with an asymmetric dimer formed by cylinders of diameters 400 nm and 200 nm according to an embodiment of the disclosed subject matter. FIG. 6B shows a symmetric formed by cylinders of diameter 400 nm, and FIG. 6C shows a trimer formed by a cylinder of diameter 400 nm and two cylinders of diameter 200 nm on transparent electrode for outcoupling according to embodiments of the disclosed subject matter. The height of the cylinders shown in FIGS. 6A-6C is 100 nm, according to embodiments of the disclosed subject matter.

FIGS. 6D-6E show the simulated TE EQE (FIG. 6D) and TE/BE (FIG. 6E) curves for the OLED structures shown in FIGS. 6A-6C according to embodiments of the disclosed subject matter. That is, FIGS. 6D-6E show simulation results for dimers and trimer formed by the dielectric cylinders, showing enhanced TE EQE for asymmetric dimer formed by cylinders of different diameter (dotted curve), symmetric dimer formed by cylinders of same diameter (dashed curve) and trimer (solid curve) formed by a cylinder of larger diameter and two cylinders of smaller diameter. The plots in FIG. 6E indicate emission anisotropy for the dimer and trimer assemblies formed by the cylinder, showing significantly higher TE EQE compared to BE EQE.

The simulation results shown in FIGS. 5D-5E and FIGS 6D-6E indicate that the assemblies of multiple dielectric particles on the transparent electrodes in low-loss OLED devices may be used to control and direct light emission without using any additional optical element in the display panels. In some embodiments, random arrays of such particle assemblies may be formed by the particles of the same and/or different shapes, sizes, and/or refractive index on the transparent electrode as the outcoupling layer.

FIG. 7 shows the estimated Purcell enhancement due to a single cylinder of diameter 400 nm as well as the symmetric and asymmetric dimer and trimer assemblies of the cylinder formed with 200 nm diameter cylinder showing a moderate Purcell enhancement at peak EQE values. That is, FIG. 7 shows estimated Purcell enhancement for a single isotropic emitter due to single cylinder of diameter 400 nm (solid curve), asymmetric dimer formed by cylinders of diameter 400 nm and 200 nm(dashed curve), symmetric dimer formed by cylinders of diameter 400nm (short dash) and trimer(dotted curve) formed by one cylinder of diameter 400 nm and two cylinders of diameters 200 nm.

In some embodiments, a periodic array of high index dielectric particles may be used as the outcoupling layer as shown in FIGS. 8A-8C. The scattering wavelength and efficiency may be tuned by controlling the array periodicity, particle shape, size, and/or the array symmetry. In this case, one or more dielectric particles or each dielectric particle may be considered as a Huygen's source. The transmission efficiency of such ordered arrays may depend on the spectral overlap between the electric and magnetic dipolar resonances, which may enhance the Purcell factor. Although in several embodiments the simulations indicate a moderate Purcell enhancement for the low-loss OLED devices, the device stability and lifetime comparable to plasmonic OLED devices may be achieved by driving them at lower current densities without significant loss in the brightness owing to the enhanced EQE values.

In some embodiments, the periodic structures of dielectric materials will be fabricated on the electrode layer, example of FIG. 8A or will be part of the electrodes directly as shown in FIG. 8C. In some embodiments, the individual particles in the periodic array may be replaced with assemblies of multiple particles with same and/or different shapes, sizes, and/or refractive index values. In some embodiments, the lattice periodicity will be changed in different ordering direction to control the directional emission from the device. The center-to-center interparticle spacing of the particles in any ordered direction may be less than 300 nm, less than 400 nm, less than 500 nm, or less than 600 nm. In some embodiments, the first plurality of nanoparticles of the periodic array may be cubic, cylindrical, cuboidal, or spherical. An in-plane dimension of the first plurality of nanoparticles may be at least 100 nm, at least 200 nm, at least 300 nm, and/or at least 500 nm. An out-of-plane dimension of the first plurality of nanoparticles may be at least 50 nm, at least 150 nm, at least 300 nm, and/or at least 500 nm. In some embodiments, the emission couples to the grating modes of the arrays and the emission direction may be tuned by controlling the nanoparticle periodicity. In some embodiments, the coupling of emission to the grating modes may result in a light emission predominantly directed normal to the device.

In some embodiments, periodic arrays of dielectric particles with tapered ends may be used, as shown in FIGS. 9A-9D. The particles may have shapes such as cones, square pyramid, particles with square base and curved faces, parabolic cone, and the like with the tapered end facing away from the OLED may be fabricated on the electrode layer. The particles may be fabricated with the highest density possible to achieve high fill fraction near the electrode layer. The shortest edge-to-edge spacing between the particles may be less than 100 nm, less than 50 nm, less than 25 nm or more preferably less than 10 nm. The edge-to edge spacing between the particles may vary in the out-of-plane direction. Based on the particle shape, the effective fill fraction of the particles may be reduced in the planes away from the electrodes, which may result in a refractive index gradient which may effectively enhance the light transmission from the OLED structures. The particle heights of the order of wavelength of light may be used. The particle layer may act as an anti-reflective coating, which may reduce the ambient light reflection from the OLED. The largest in-plane dimension of the particles may be at least 100 nm, at least 200 nm, at least 300 nm, or at least 500 nm. The out-of-plane dimension of the particles may be at least 150 nm, at least 300 nm, at least 600 nm, or at least 1 µm.

The arrays of high index particles on electrodes may be prepared by the various top-down and bottom-up approaches such as lithography-based techniques, multi photon absorption photopolymerization of the resins with or without nanoparticle inclusions using a focused laser beam, nanosphere lithography, directed self-assembly based methods using particles prepared by chemical synthesis or photopolymerization, or the like.

In some embodiments, a thin layer of high index material may be placed on the electrode layer. In some embodiments, the device may have a thin transparent layer on top of the nanoparticle layer. In some embodiments, the dielectric particle arrays may be fabricated on the second electrode. A first or second layer may be disposed on top of the nanoparticle outcoupling layer in some embodiments. The nanoparticle outcoupling layer may be formed by first forming a thin film and then utilizing subtractive etching methods to form the nanoparticles. In other embodiments, the nanoparticles may be formed through another synthesis method and then deposited on the substrate. The nanoparticles are formed on the OLED substrate by physical vapor deposition in some embodiments.

In some embodiments, the device may have a first side and a second side, and the emission of light may come from the first side of the device. In some embodiments, a highly reflective layer may be placed on the second side of the device to direct the emission to the first side of the device. The first electrode may be replaced with a thick metal layer to reflect the light to the first side of the device, with the emissive layer dispose at least 75 nm from the metallic electrode to minimize the metallic loss according to embodiments of the disclosed subject matter. The thickness of the metal layer may be at least 50 nm, and preferably about 200 nm to ensure near unity reflectivity from the layer. In some embodiments, a distributed Bragg reflector (DBR) stack may be used to reflect the light from the second side of the device. The DBR stack may have at least 2-3 pairs of layers, more preferably 10 pairs of layers, and preferably not more than 20 pairs of layer due to the time required to manufacture the DBR. The number of pairs may depend on the refractive index difference between high and low index material layers. In some embodiments, the transparent electrode layer may be deposited directly to the emissive layer to enhance the Purcell or the efficiency of the device.

In some embodiments, the refractive index of the nanofeatures responsible for outcoupling is at least 1.9, more preferably at least 2.1, and most preferably more than 2.5. In some embodiments, the nanoparticles may be composed of materials that have minimal absorption in the spectral range of outcoupling. This may prevent any loss due to absorption when the nanoparticle scatters energy out of the OLED. In some embodiments, the absorption of the nanoparticle may be tuned to a specific value which may modify the electric and magnetic dipolar resonances and change their relationship at various wavelengths of emission.

In some embodiments, the high dielectric nanoparticle outcoupling layer may be adjacent to a metallic electrode. The high dielectric nanoparticle outcoupling layer may be adjacent to the electrode, and the nanoparticles are arranged to dimers, trimers, or higher-level units in some embodiments. For all the embodiments described above, the overall thickness of the OLED stack having a plurality of layers may range between 50 -600 nm. The thickness of the emissive layer may be at least 0.2 nm and not more than 75 nm, and may located preferably not more than 500 nm from the transparent electrode on which the nanoparticles forming the outcoupling layer will be fabricated. The nanoparticles may be disposed on the second electrode, which may be the transparent electrode. More preferably, the emissive layer may be within 10-200 nm from the transparent electrode on which the nanoparticles forming the outcoupling layer will be fabricated. The dimensions of the particles in-plane to the transparent electrode may range between 200 - 800 nm, and more preferably within 400-600 nm. The out-of-plane dimensions of the particle may range between 25 - 600 nm, and more preferably within 75-200 nm.

In some of the embodiments described above in connection with FIGS. 3A-9D, a device may include an organic light emitting device (OLED) having a substrate, a first electrode disposed over the substrate, a second electrode disposed over the first electrode, and an organic emissive layer disposed between the first electrode and the second electrode, where the organic emissive layer may have a first surface positioned over a second surface. A nanoparticle layer may be disposed over the organic emissive layer, and the nanoparticle layer may have a first surface that is positioned over a second surface. The nanoparticle layer may include a first plurality of nanoparticles comprising a dielectric material, and a surrounding medium. A distance from the second surface of the nanoparticle layer to the first surface of the organic emissive layer may not be more than 50 nm, and there may be a difference of at least 1.0 between a refractive index of the dielectric material and the surrounding medium. The distance from the second surface of the nanoparticle layer to the first surface of the organic emissive layer may be, for example, 1-10 nm, 10-20nm, 20-30 nm, 30-40 nm, or 40-50 nm.

The organic emissive layer of the device may have a thickness that is at least 0.2 nm, but not more than 75 nm. In some embodiments, the organic emissive layer of the device is disposed from the second electrode by at least 10 nm, at least 100 nm, at least 300 nm, and/or at least 600 nm. The OLED may be a stack having a plurality of layers, and a thickness of the stack is 50 - 600 nm.

The first plurality of nanoparticles of the nanoparticle layer of the device may be disposed in an outcoupling layer disposed over the second electrode. In some embodiments, at least some of the nanoparticles of the device may be integrated with the second electrode. The arrangement of the nanoparticles in the nanoparticle layer of the device may result in an external quantum efficiency (EQE) of at least 15%. The nanoparticles of the nanoparticle layer may include at least one nanoparticle having a Mie scattering efficiency of 2-8 based. The Mie scattering efficiency value may be based on a size of the nanoparticles, a shape of the nanoparticles, and/or a material refractive index of the nanoparticles. For example, a refractive index of the first plurality of nanoparticles may be at least 1.9, at least 2.1, at least 2.5, and/or less than 3.5. The arrangement of the first plurality of nanoparticles may result in an external quantum efficiency (EQE) of at least 30%, of at least 50% or the like.

The nanoparticles of the nanoparticle layer may include silicon, silicon nitride, boron nitride, silicon carbide, carbon, diamond, zinc sulfide, zinc selenide, germanium, zinc telluride, potassium niobate, titanium oxide, antimony oxide, niobium pentoxide, tantalum pentoxide, vanadium oxide, vanadium pentoxide, gallium phosphate, bismuth oxide, gallium arsenide, and/or aluminum gallium. The dielectric material of the first plurality of nanoparticles may absorb not more than 50% of the light energy in a spectral range of outcoupling. In some embodiments, the dielectric material of the first plurality of nanoparticles may absorb not more than 20% of the light energy in a spectral range of outcoupling.

The first plurality of nanoparticles may have a single configuration or may have multiparticle configurations. For example, the multiparticle configurations may include dimers, trimers, and/or higher-level units (e.g., units that include a pluarlity of levels). The nanoparticles in these arrangements may be configured to output a non-Lambertian emission. The device may be configured to emit at least 60%, at least 70%, and/or at least 80% of the light through one side of the device side where the nanoparticles are disposed.

The nanoparticles of the device may include two or more materials, each having materials of a different refractive index, that are homogeneously or inhomogeneously distributed within the outcoupling layer, where at least one of the two or more materials creates the difference of at least 1.0 between the refractive index of the at least one of the two or more materials and the surrounding medium. The nanoparticles may be shaped as a cube, a cylinder, a sphere, a spheroid, a parallelopiped shape, a rod-shape, a star-shape, a pyramidal shape, an amorphous shape, and/or a multi-faceted three-dimensional object. There may be differences between at least two of the first plurality of nanoparticles. These differences may include sizes, shapes, and/or indices of refraction.

The nanoparticles of the device may be configured in a periodic array, such as shown in FIG. 8A. A scattering wavelength and efficiency of the nanoparticles in the periodic array may be based on array periodicity, a shape of the particles, a size of the particles, and/or a symmetry of the array. At least two nanoparticles in the periodic array may have the same shape, different shapes, the same size, different sizes, the same refractive index values, and/or different refractive index values. A lattice periodicity of the periodic array may be configured to output a non-Lambertian emission from the device. The nanoparticles of the periodic array may have a shape that is a conical shape, a square pyramid shape, a shape having a square base and a curved face, and/or a parabolic cone shape, such as shown in FIGS. 9A-9D. The shape of the nanoparticles such as shown in FIGS. 9A-9D may have a tapered end facing away from the OLED, and the first plurality of nanoparticles may be integrated with the first electrode or the second electrode.

The device may include a second plurality of nanoparticles having a dielectric material that is disposed over the first plurality of nanoparticles that are disposed over the second electrode. A first layer may be disposed over the first plurality of nanoparticles, and a second layer disposed over the second plurality of nanoparticles.

The device may include a transparent layer disposed on the first plurality of nanoparticles. The transparent layer may be a layer that allows at least 50%, at least 70%, at least 80%, and/or at least 90% of light emitted from an emissive layer of the OLED to pass through. The transparent layer may include a dielectric material having a refractive index less than 1.2, less than 1.5, less than 2, less than 2.5, and/or less than 3. The effective refractive index of the transparent layer may be less than the ranges detailed here, as the layer thickness can be less than the particle height, and the index difference of 1 with particle material may still be satisfied.

The device may include a transparent dielectric layer, which may have a thickness at least 2 nm but not more than 50 nm minus a thickness of the electrode. The transparent dielectric layer may be disposed between the second electrode and the nanoparticle layer. A refractive index of the dielectric material may be less than 1.2, less than 1.5, less than 2, and/or less than 2.5.

The device may have a first side and a second side. The first electrode may include a reflective metal layer to reflect light to the first side of the device. The second electrode may be a transparent layer, and the nanoparticle layer is disposed over the transparent layer. The organic emissive layer may be disposed at least 75 nm from the reflective metal layer. A thickness of the reflective metal layer may be at least 50 nm, at least 100 nm, at least 150 nm, at least 200 nm, and/or less than 300 nm. In some embodiments, light may be emitted from both the first side and the second side. A thickness of the second electrode may be 10-20 nm, 20-50 nm, and/or 50-100 nm.

The device may include a reflective layer and/or partially reflective layer disposed on the first side or the second side of the device to direct emission of light from the device. The partially reflective or reflective layer may have a reflectivity of at least 40%, at least 50%, at least 70%, and/or at least 90%.

The device may include a distributed Bragg reflector (DBR) stack disposed to reflect light from a second side of the device. The substrate may have a first side and a second side, and the DBR stack may be disposed on the first side and/or the second side of the substrate. An OLED stack may be disposed on the first side of the substrate. In some embodiments, the DBR may be disposed on the first side of the substrate, and the OLED may be disposed on the DBR. The DBR stack may include at least 2 pair of layers, at least three pairs of layer, at least 5 pairs of layers, at least 10 pairs of layers, and/or not more than 20 pairs of layers. The number of pairs of layers may be based on a refractive index difference between a first index material layer and a second index material layer. The first index material and second index material may form a pair. The first index material may be made of one material type with particular index value and second index material will be made of different material with index value different from first index material. The first index material layer may be a high index of at least 1.6, at least 2, at least 2.3, and/or less than 3.5, and the second material index layer may be a low index of less than 1.2, and/or less than 1.6.

The first electrode and/or the second electrode may be a transparent electrode, where the nanoparticles may be disposed on the second electrode. An in-plane dimension of the nanoparticles may be 200-400 nm, 400-600nm, and/or 600-800 nm, where the in-plane dimension is in a plane that is horizontal to the substrate. A distance in an out-of-plane dimension between the nanoparticles may be 25-75 nm, 75-200nm, 200-400 nm, and/or 400-600 nm, where the out-of-plane dimension is in a plane perpendicular to the substrate.

An in-plane dimension of the nanoparticles may be between 200-400 nm, 400-600nm, and/or 600-800 nm, where the in-plane dimension is in a plane that is horizontal to the substrate. A distance of an out-of-plane dimension between the nanoparticles may be 25-75 nm, 75-200nm, 200-400 nm, and/or 400-600 nm, where the out-of-plane dimension is in a plane perpendicular to the substrate.

The first electrode and/or the second electrode of the device may include indium tin oxide, fluorine doped tin oxide, indium doped zinc oxide, Aluminum Zinc Oxide, indium-doped cadmium oxide, barium stannate, carbon nanotubes, graphene, multilayer graphene, single layer graphene, graphene oxide, metallic nano particle or nanowire impregnated materials, as well as conductive polymers such as polyacetylene, polypyrrole, polyindole, polyaniline, Poly(p-phenylene vinylene), and/or poly(3-alkylthiophenes), (poly(3,4-ethylenedioxythiophene)).

The first electrode and/or the second electrode of the device may include polymers, oxide materials, nano-sized metallic nanoparticles, and/or metal nanowires. The first electrode and/or the second electrode may include a multilayer that is indium tin oxide, fluorine doped tin oxide, indium doped zinc oxide, aluminum zinc oxide, indium-doped cadmium oxide, barium stannate, carbon nanotubes, graphene, multilayer graphene, single layer graphene, graphene oxide, metallic nanoparticle or nanowire impregnated materials, polyacetylene, polypyrrole, polyindole, polyaniline, Poly(p-phenylene vinylene), and/or poly(3-alkylthiophenes), (poly(3,4-ethylenedioxythiophene)). The first electrode and/or the second electrode may include a metal layer having a thickness of 2-5 nm and/or 6-10 nm. The organic emissive layer may be disposed at least 75 nm from the metal layer.

The second electrode of the device may be a metallic electrode, and the nanoparticle layer may be disposed over the metallic electrode. The first plurality of nanoparticles of the nanoparticle layer may be configured as dimers, trimers, and/or a plurality of levels of units to be configured to output a non-Lambertian emission. The organic emissive layer of the device may a first surface positioned over a second surface, the metallic electrode of the device may have a first surface positioned over a second surface, and the distance from the first surface of the organic emissive layer to a second surface of the metallic electrode is at least one selected from the group consisting of: less than 10 nm, less than 15 nm, less than 20 nm, less than 30 nm, and less than 40 nm. The metallic electrode of the device may have one or more metallic layers of silver, one or more metallic layers of aluminum, and/or one or more metallic layers of gold. A distance between the first surface and the second surface of the metallic electrode may be less than 20 nm, less than 30 nm, and/or less than 50 nm. The organic emissive layer may have a thickness that is less than 1 nm, less than 2 nm, less than 5 nm, and/or less than 10 nm. The organic emissive layer of the device may have a first surface positioned over a second surface, the metallic electrode of the device may have a first surface positioned over a second surface, and a distance from the first surface of the organic emissive layer to the second surface of the nanoparticle layer may be at least 20 nm, at least 30 nm, at least 40 nm, and/or at least 50 nm. A dielectric layer may be disposed between the metallic electrode and the nanoparticle layer that has a thickness that is less than 10 nm, less than 5 nm, and/or at least 2 nm. A refractive index of the dielectric layer may be at least 1.5, at least 1.75, at least 2, at least 2.5, and/or greater than 2.5.

In this mode of light outcoupling, the emitter may couple to the surface plasmon modes of the metallic electrode, and the light may be outcoupled through the hybrid plasmonic dielectric modes. For efficient coupling of the emissive layer (EL) to the surface plasmon modes of the electrodes, the emissive layer may be disposed closer to the metallic electrode. The distance from the top of the emissive layer (e.g., the first surface of the emissive layer) to the bottom of the metallic electrode may be less than 10 nm, less than 15 nm, less than 20 nm, less than 30 nm and/or less than 40 nm. Metallic layers of silver, aluminum, or gold having a thickness less than 20 nm, less than 30 nm or less than 50 nm may be used as metallic electrodes. The emissive layer may have a thickness less than 1 nm, less than 2 nm, less than 5 nm and/or less than 10 nm. The distance from the top of the emissive layer (e.g., the first surface of the emissive layer) to the bottom of the nanoparticle layer (e.g., the second surface of the nanoparticle layer) may be at least 20 nm, at least 30 nm, at least 40 nm, or at least 50 nm. In some embodiments, a dielectric layer having a thickness that is less than 10 nm, less than 5 nm, or at least 2 nm may be disposed between the metallic electrode and nano particle layer. The refractive index of dielectric layer may be at least 1.5, at least 1.75, at least 2, at least 2.5, or greater than 2.5.

The substrate of the device may be a transparent material. The device may have a first side and a second side, where the first and second electrode are transparent, and light is output from the first and second sides of the device.

According to an embodiment, a consumer electronic device may include a device may include an organic light emitting device (OLED) having a substrate, a first electrode disposed over the substrate, a second electrode disposed over the first electrode, and an organic emissive layer disposed between the first electrode and the second electrode, where the organic emissive layer may have a first surface positioned over a second surface. A nanoparticle layer may be disposed over the organic emissive layer, and the nanoparticle layer may have a first surface that is positioned over a second surface. The nanoparticle layer may include a plurality of nanoparticles comprising a dielectric material, and a surrounding medium. A distance from the second surface of the nanoparticle layer to the first surface of the organic emissive layer may not be more than 50 nm, and there may be a difference of at least 1.0 between a refractive index of the dielectric material and the surrounding medium.

The device may be a flat panel display, a curved display, a computer monitor, a medical monitor, a television, a billboard, a light for interior or exterior illumination and/or signaling, a heads-up display, a fully or partially transparent display, a flexible display, a rollable display, a foldable display, a stretchable display, a laser printer, a telephone, a cell phone, tablet, a phablet, a personal digital assistant (PDA), a wearable device, a laptop computer, a digital camera, a camcorder, a viewfinder, a micro-display that is less than 2 inches diagonal, a 3-D display, a virtual reality or augmented reality display, a vehicle, an automotive display, video walls comprising multiple displays tiled together, a theater or stadium screen, and a sign.

In some embodiments, a device may include an organic light emitting device (OLED) having a substrate, a first electrode disposed over the substrate, a second electrode disposed over the first electrode, and an organic emissive layer disposed between the first electrode and the second electrode. The organic emissive layer may have a first surface positioned over a second surface, and the nanoparticle layer may have a first surface that is positioned over a second surface. A nanoparticle layer may be disposed over the organic emissive layer. The nanoparticle layer may include a plurality of nanoparticles comprising a dielectric material, and a surrounding medium. The organic emissive layer may directly couple to the Mie scattering modes of the plurality of nanoparticles. A distance from the second surface of the nanoparticle layer to the first surface of the organic emissive layer may be not more than 1/5, not more than 1/8, and/or not more than 1/10 of a peak emission wavelength capable of being emitted by the organic emissive layer. Direct coupling may include coupling to the grating modes of the nanoparticle lattices for the ordered nanoparticle arrays, and the like.

It is understood that the various embodiments described herein are by way of example only, and are not intended to limit the scope of the invention. For example, many of the materials and structures described herein may be substituted with other materials and structures without deviating from the spirit of the invention. The present invention as claimed may therefore include variations from the particular examples and preferred embodiments described herein, as will be apparent to one of skill in the art. It is understood that various theories as to why the invention works are not intended to be limiting.

The invention is further described by the following numbered aspects:
1. A device comprising: an organic light emitting device (OLED) comprising: a substrate; a first electrode disposed over the substrate; a second electrode disposed over the first electrode; and an organic emissive layer disposed between the first electrode and the second electrode, the organic emissive layer having a first surface positioned over a second surface; and a nanoparticle layer disposed over the organic emissive layer, the nanoparticle layer having a first surface that is positioned over a second surface, the nanoparticle layer comprising: a first plurality of nanoparticles comprising a dielectric material; and a surrounding medium; wherein a distance from the second surface of the nanoparticle layer to the first surface of the organic emissive layer is not more than 50 nm, and wherein there is a difference of at least 1.0 between a refractive index of the dielectric material and the surrounding medium.
2. The device of aspect 1, wherein the first plurality of nanoparticles is disposed in an outcoupling layer disposed over the second electrode.
3. The device of aspect 1, wherein at least some of the first plurality of nanoparticles are integrated with the second electrode.
4. The device of aspect 1, wherein the arrangement of the first plurality of nanoparticles results in an external quantum efficiency (EQE) of at least 15%.
5. The device of aspect 1, wherein the first plurality of nanoparticles includes at least one nanoparticle having a Mie scattering efficiency of 2-8 based on at least one selected from the group consisting of: a size of the nanoparticles, a shape of the nanoparticles, and a material refractive index of the nanoparticles.
6. The device of aspect 1, wherein a refractive index of the first plurality of nanoparticles is at least one selected from the group consisting of: at least 1.9, at least 2.1, at least 2.5, and less than 3.5.
7. The device of aspect 1, wherein the first plurality of nanoparticles include at least one selected from the group consisting of: silicon, silicon nitride, boron nitride, silicon carbide, carbon, diamond, zinc sulfide, zinc selenide, germanium, zinc telluride, potassium niobate, titanium oxide, antimony oxide, niobium pentoxide, tantalum pentoxide, vanadium oxide, vanadium pentoxide, gallium phosphate, bismuth oxide, gallium arsenide, and aluminum gallium.
8. The device of aspect 1, wherein the first plurality of nanoparticles have a single configuration, or multiparticle configurations.
9. The device of aspect 1, wherein the first plurality of nanoparticles is configured as at least one selected from the group consisting of: dimers, trimers, and a plurality of levels of units to be configured to output a non-Lambertian emission.
10. The device of aspect 9, wherein the device is configured to emit at least one selected from the group consisting of: at least 60%, at least 70%, and at least 80% of the light through one side of the device side where the plurality nanoparticles are disposed.
11. The device of aspect 1, wherein the first plurality of nanoparticles comprises two or more materials, each of the two or more materials having a different refractive index, homogeneously or inhomogeneously distributed within the outcoupling layer, wherein at least one of the two or more materials creates the difference of at least 1.0 between the refractive index of the at least one of the two or more materials and the surrounding medium.
12. The device of aspect 1, wherein a shape of the nanoparticles is at least one from the group consisting of: a cube, a cuboid, a cylinder, a sphere, a spheroid, a parallelopiped shape, a rod-shape, a star-shape, a pyramidal shape, an amorphous shape, and a multi-faceted three-dimensional object.
13. The device of aspect 1, wherein differences between at least two of the first plurality of nanoparticles include at least one selected from the group consisting of: sizes, shapes, and indices of refraction.
14. The device of aspect 1, wherein the first plurality of nanoparticles is configured in a periodic array.
15. The device of aspect 14, wherein a scattering wavelength and efficiency of the first plurality of nanoparticles in the periodic array is based on at least one selected from the group consisting of: array periodicity, a shape of the particles, a size of the particles, and a symmetry of the array.
16. The device of aspect 14, wherein at least two nanoparticles in the periodic array have at least one selected from the group consisting of: the same shape, different shapes, the same size, different sizes, the same refractive index values, and different refractive index values.
17. The device of aspect 14, wherein a lattice periodicity of the periodic array is configured to output a non-Lambertian emission from the device.
18. The device of aspect 14, wherein the first plurality of nanoparticles of the periodic array have a shape that is at least one selected from the group consisting of: a conical shape, a square pyramid shape, a shape having a square base and a curved face, and a parabolic cone shape.
19. The device of aspect 18, wherein the shape of the first plurality of nanoparticles has a tapered end facing away from the OLED, and wherein the first plurality of nanoparticles is integrated with the first electrode or the second electrode.
20. The device of aspect 18, wherein a largest in-plane dimension of the first plurality of nanoparticles is at least one selected from the group consisting of: at least 100 nm, at least 200 nm, at least 300 nm, and at least 500 nm.
21. The device of aspect 18, wherein an out-of-plane dimension of the first plurality of nanoparticles is at least one selected from the group consisting of: at least 150 nm, at least 300 nm, at least 600 nm, and at least 1 µm.
22. The device of aspect 18, wherein a shortest edge-to-edge spacing between the first plurality of nanoparticles is at least one selected from the group consisting of: less than 100 nm, less than 50 nm, less than 25 nm, and less than 10 nm.
23. The device of aspect 18, wherein the shortest edge-to-edge spacing between the first plurality of nanoparticles is in a plane of an in-plane direction, wherein the in-plane direction is a plane horizontal to the substrate.
24. The device of aspect 14, wherein the first plurality of nanoparticles of the periodic array has a shape that is selected from the group consisting of: cubic, cylindrical, cuboidal, and spherical.
25. The device of aspect 24, wherein a center-to-center interparticle spacing of the first plurality of nanoparticles in any ordered direction is at least one selected from the group consisting of: less than 300nm, less than 400 nm, less than 500 nm, and less than 600 nm.
26. The device of aspect 24, wherein an in-plane dimension of the first plurality of nanoparticles is at least one selected from the group consisting of: at least 100 nm, at least 200 nm, at least 300 nm, and at least 500 nm.
27. The device of aspect 24, wherein an out-of-plane dimension of the first plurality of nanoparticles is at least one selected from the group consisting of: at least 50 nm, at least 150 nm, at least 300 nm, at least 500 nm.
28. The device of aspect 1, further comprising: a transparent dielectric layer having a thickness at least 2 nm but not more than 50 nm minus a thickness of the electrode, wherein the transparent dielectric layer is disposed between the second electrode and the nanoparticle layer.
29. The device of aspect 28, wherein a refractive index of the dielectric material is at least one selected from the group consisting of: less than 1.2, less than 1.5, less than 2, and less than 2.5.
30. The device of aspect 1, further comprising: a transparent layer disposed on the first plurality of nanoparticles.
31. The device of aspect 30, wherein the transparent layer comprises a dielectric material having a refractive index selected from the group consisting of: less than 1.2, less than 1.5, less than 2, less than 2.5, and less than 3.
32. The device of aspect 1, wherein a second plurality of nanoparticles comprises a dielectric material that is disposed over the first plurality of nanoparticles that are disposed over the second electrode.
33. The device of aspect 32, further comprising at least one selected from the group consisting of: a first layer disposed over the first plurality of nanoparticles, and a second layer disposed over the second plurality of nanoparticles.
34. The device of aspect 1, wherein the device has a first side and a second side, wherein the first electrode comprises a reflective metal layer to reflect light to the first side of the device, wherein the second electrode is a transparent layer, and wherein the nanoparticle layer is disposed over the transparent layer, and wherein the organic emissive layer is disposed at least 75 nm from the reflective metal layer.
35. The device of aspect 34, wherein a thickness of the reflective metal layer is at least one selected from the group consisting of: at least 50 nm, at least 100 nm, at least 150 nm, at least 200 nm, and less than 300 nm.
36. The device of aspect 1, wherein the device has a first side and a second side, and light is emitted from both the first side and the second side.
37. The device of aspect 1, wherein the device has a first side and a second side, and the device further comprises: a reflective layer disposed on the second side to direct emission of light to the first side of the device.
38. The device of aspect 1, wherein the device has a first side and a second side, and the device further comprises: a distributed Bragg reflector (DBR) stack disposed to reflect light from a second side of the device.
39. The device of aspect 38, wherein the substrate has a first side and a second side, and the DBR stack is disposed on at least one selected from the group consisting of: the first side, and the second side of the substrate.
40. The device of aspect 39, wherein the DBR is disposed on the first side of the substrate, and the OLED is disposed on the DBR.
41. The device of aspect 38, wherein the DBR stack includes at least one selected from the group consisting of: at least 2 pair of layers, at least three pairs of layer, at least 5 pairs of layers, at least 10 pairs of layers, and not more than 20 pairs of layers.
42. The device of aspect 41, wherein the number of pairs of layers is based on a refractive index difference between a first index material layer and a second index material layer.
43. The device of aspect 42, wherein the first index material layer has an index that is at least one selected from the group consisting of: at least 1.6, at least 2, at least 2.3, and less than 3.5, and wherein the second index material layer has an index that is at least one selected from the group consisting of: less than 1.2, and less than 1.6.
44. The device of aspect 1, wherein at least one selected from the group consisting of the first electrode and the second electrode is a transparent electrode.
45. The device of aspect 44, wherein the second electrode is the transparent electrode, and the transparent electrode is disposed on the organic emissive layer.
46. The device of aspect 45, wherein an in-plane dimension of the nanoparticles is at least one selected from the group consisting of: 200-400 nm, 400-600nm, and 600-800 nm, wherein the in-plane dimension is in a plane that is horizontal to the substrate, and wherein a distance in an out-of-plane dimension between the nanoparticles is at least one selected from the group consisting of: 25-75 nm, 75-200nm, 200-400 nm, and 400-600 nm, wherein the out-of-plane dimension is in a plane perpendicular to the substrate.
47. The device of aspect 1, wherein an in-plane dimension of the nanoparticles is at least one selected from the group consisting of: 200-400 nm, 400-600nm, and 600-800 nm, wherein the in-plane dimension is in a plane that is horizontal to the substrate and wherein a distance in an out-of-plane dimension between the nanoparticles is at least one selected from the group consisting of: 25-75 nm, 75-200nm, 200-400 nm, and 400-600 nm, wherein the out-of-plane dimension is in a plane perpendicular to the substrate.
48. The device of aspect 1, wherein the OLED comprises a stack having a plurality of layers, and a thickness of the stack is 50 - 600 nm.
49. The device of aspect 1, wherein the organic emissive layer has a thickness that is at least 0.2 nm, but not more than 75 nm.
50. The device of aspect 1, wherein the organic emissive layer is disposed from the second electrode by at least one selected from the group consisting of: at least 10 nm, at least 100 nm, at least 300 nm, and at least 600 nm.
51. The device of aspect 1, wherein the arrangement of the first plurality of nanoparticles results in an external quantum efficiency (EQE) of at least 30%.
52. The device of aspect 1, wherein the first plurality of nanoparticles is arranged to have an external quantum efficiency (EQE) of at least 50%.
53. The device of aspect 1, wherein at least one selected from the group consisting of:
   (a) the first electrode, and (b) the second electrode
   comprises at least one selected from the group consisting of: indium tin oxide, fluorine doped tin oxide, indium doped zinc oxide, Aluminum Zinc Oxide, indium-doped cadmium oxide, barium stannate, carbon nanotubes, graphene, multilayer graphene, single layer graphene, graphene oxide, metallic nano particle or nanowire impregnated materials, as well as conductive polymers such as polyacetylene, polypyrrole, polyindole, polyaniline, Poly(p-phenylene vinylene), and poly(3-alkylthiophenes), (poly(3,4-ethylened ioxythiophene)).
54. The device of aspect 1, wherein at least one selected from the group consisting of:
   (a) the first electrode, and (b) the second electrode
   comprises at least one selected from the group consisting of: polymers, oxide materials, nano-sized metallic nanoparticles, and metal nanowires.
55. The device of aspect 1, wherein at least one selected from the group consisting of:
   (a) the first electrode, and (b) the second electrode
   comprises a multilayer selected from the group consisting of: indium tin oxide, fluorine doped tin oxide, indium doped zinc oxide, aluminum zinc oxide, indium-doped cadmium oxide, barium stannate, carbon nanotubes, graphene, multilayer graphene, single layer graphene, graphene oxide, metallic nanoparticle or nanowire impregnated materials, polyacetylene, polypyrrole, polyindole, polyaniline, Poly(p-phenylene vinylene), and poly(3-alkylthiophenes), (poly(3,4-ethylenedioxythiophene)).
56. The device of aspect 55, wherein at least one selected from the group consisting of:
   (a) the first electrode, and (b) the second electrode
   includes a metal layer having a thickness of at least one selected from the group consisting of: 2-5 nm, and 6-10 nm.
57. The device of aspect 56, wherein the organic emissive layer is disposed at least 75 nm from the metal layer.
58. The device of aspect 1, wherein the second electrode is a metallic electrode, and the nanoparticle layer is disposed over the metallic electrode.
59. The device of aspect 58, wherein the first plurality of nanoparticles of the nanoparticle layer is configured as at least one selected from the group consisting of: dimers, trimers, and a plurality of levels of units to be configured to output a non-Lambertian emission.
60. The device of aspect 58, wherein the organic emissive layer has a first surface positioned over a second surface, wherein the metallic electrode has a first surface positioned over a second surface, and wherein the distance from the first surface of the organic emissive layer to a second surface of the metallic electrode is at least one selected from the group consisting of: less than 10 nm, less than 15 nm, less than 20 nm, less than 30 nm, and less than 40 nm.
61. The device of aspect 58, wherein the metallic electrode comprises at least one selected from the group consisting of: one or more metallic layers of silver, one or more metallic layers of aluminum, and one or more metallic layers of gold, wherein a distance between the first surface and second surface of the metallic electrode is at least one selected from the group consisting of: less than 20 nm, less than 30 nm, and less than 50 nm.
62. The device of aspect 61, wherein the organic emissive layer has a thickness comprising at least one selected from the group consisting of: less than 1 nm, less than 2 nm, less than 5 nm, and less than 10 nm.
63. The device of aspect 58, wherein the organic emissive layer has a first surface positioned over a second surface, wherein the metallic electrode has a first surface positioned over a second surface, and wherein a distance from the first surface of the organic emissive layer to the second surface of the nanoparticle layer is at least one selected from the group consisting of: at least 20 nm, at least 30 nm, at least 40 nm, and at least 50 nm.
64. The device of aspect 58, further comprising a dielectric layer disposed between the metallic electrode and the nanoparticle layer has a thickness that is at least one selected from the group consisting of: less than 10 nm, less than 5 nm, and at least 2 nm.
65. The device of aspect 64, wherein a refractive index of the dielectric layer is at least one selected from the group consisting of: at least 1.5, at least 1.75, at least 2, at least 2.5, and greater than 2.5.
66. The device of aspect 1, wherein a thickness of the second electrode is at least one selected from the group consisting of: 10-20 nm, 20-50 nm, and 50 -100 nm.
67. The device of aspect 1, wherein the substrate is a transparent material.
68. The device of aspect 1, wherein the device has a first side and a second side, and wherein the first electrode and the second electrode are transparent, and light is output from the first side and the second side.
69. The device of aspect 1, wherein the dielectric material of the first plurality of nanoparticles absorbs not more than 50% of the light energy in a spectral range of outcoupling.
70. The device of aspect 1, the dielectric material of the first plurality of nanoparticles absorbs not more than 20% of the light energy in a spectral range of outcoupling.
71. The device of aspect 1, wherein the cathode is provided no more than a threshold distance away from the organic emissive layer, wherein an emitter material in the organic emissive layer has a total non-radiative decay rate constant and a total radiative decay rate constant due to the presence of the cathode and the threshold distance is where the total non-radiative decay rate constant is equal to the total radiative decay rate constant.
72. The device of aspect 23, wherein a side with the shortest edge-to-edge spacing between the first plurality of nanoparticles is closer to the substrate than a side with the longest edge-to-edge spacing between the first plurality of nanoparticles.
73. A consumer electronic device comprising: an organic light emitting device (OLED) comprising: a substrate; a first electrode disposed over the substrate; a second electrode disposed over the first electrode; and an organic emissive layer disposed between the first electrode and the second electrode, the organic emissive layer having a first surface positioned over a second surface; and a nanoparticle layer disposed over the organic emissive layer, the nanoparticle layer having a first surface that is positioned over a second surface, the nanoparticle layer comprising: a plurality of nanoparticles comprising a dielectric material; and a surrounding medium; wherein a distance from the second surface of the nanoparticle layer to the first surface of the organic emissive layer is not more than 50 nm, and wherein there is a difference of at least 1.0 between a refractive index of the dielectric material and the surrounding medium.
74. The consumer electronic device of aspect 73, wherein the device is at least one type selected from the group consisting of: a flat panel display, a curved display, a computer monitor, a medical monitor, a television, a billboard, a light for interior or exterior illumination and/or signaling, a heads-up display, a fully or partially transparent display, a flexible display, a rollable display, a foldable display, a stretchable display, a laser printer, a telephone, a cell phone, tablet, a phablet, a personal digital assistant (PDA), a wearable device, a laptop computer, a digital camera, a camcorder, a viewfinder, a micro-display that is less than 2 inches diagonal, a 3-D display, a virtual reality or augmented reality display, a vehicle, an automotive display, video walls comprising multiple displays tiled together, a theater or stadium screen, and a sign.
75. A device comprising: an organic light emitting device (OLED) comprising: a substrate; a first electrode disposed over the substrate; a second electrode disposed over the first electrode; and an organic emissive layer disposed between the first electrode and the second electrode, the organic emissive layer having a first surface positioned over a second surface; and a nanoparticle layer disposed over the organic emissive layer, the nanoparticle layer having a first surface that is positioned over a second surface, the nanoparticle layer comprising: a plurality of nanoparticles comprising a dielectric material; and a surrounding medium; wherein the organic emissive layer directly couples to Mie scattering modes of the plurality of nanoparticles, and wherein a distance from the second surface of the nanoparticle layer to the first surface of the organic emissive layer is at least one selected from the group consisting of: not more than 1/5, not more than 1/8, and not more than 1/10 of a peak emission wavelength capable of being emitted by the organic emissive layer.
76. The device of aspect 75, wherein the direct coupling includes a coupling to grating modes of nanoparticle lattices for ordered nanoparticle arrays.

## Claims

1. A device comprising:
an organic light emitting device (OLED) comprising:
a substrate;
a first electrode disposed over the substrate;
a second electrode disposed over the first electrode; and
an organic emissive layer disposed between the first electrode and the second electrode, the organic emissive layer having a first surface positioned over a second surface; and
a nanoparticle layer disposed over the organic emissive layer, the nanoparticle layer having a first surface that is positioned over a second surface, the nanoparticle layer comprising:
a first plurality of nanoparticles comprising a dielectric material; and
a surrounding medium;
wherein a distance from the bottom of the nanoparticle layer to the top of the organic emissive layer is not more than 50 nm, and
wherein there is a difference of at least 1.0 between a refractive index of the dielectric material and the surrounding medium.

2. The device of claim 1, wherein the plurality of nanoparticles is disposed in an outcoupling layer disposed over the second electrode.

3. The device of claim 1, wherein at least some of the plurality of nanoparticles are integrated with the second electrode.

4. The device of claim 1, wherein the plurality of nanoparticles includes at least one nanoparticle having a Mie scattering efficiency of 2-8 based on at least one selected from the group consisting of: a size of the nanoparticles, a shape of the nanoparticles, and a material refractive index of the nanoparticles.

5. The device of claim 1, wherein the plurality of nanoparticles is configured as at least one selected from the group consisting of: dimers, trimers, and a plurality of levels of units to be configured to output a non-Lambertian emission.

6. The device of claim 5, wherein the device is configured to emit at least one selected from the group consisting of: at least 60%, at least 70%, and at least 80% of the light through one side of the device side where the plurality nanoparticles are disposed.

7. The device of claim 1, further comprising:
a transparent dielectric layer having a thickness at least 2 nm but not more than 50 nm minus a thickness of the electrode, wherein the transparent dielectric layer is disposed between the second electrode and the nanoparticle layer.

8. The device of claim 1, wherein the device has a first side and a second side,
wherein the first electrode comprises a reflective metal layer to reflect light to the first side of the device,
wherein the second electrode is a transparent layer, and
wherein the nanoparticle layer is disposed over the transparent layer, and
wherein the organic emissive layer is disposed at least 75 nm from the reflective metal layer.

9. The device of claim 1, wherein the device has a first side and a second side, and the device further comprises:
a distributed Bragg reflector (DBR) stack disposed to reflect light from a second side of the device.

10. The device of claim 1, wherein at least one selected from the group consisting of the first electrode and the second electrode is a transparent electrode.

11. The device of claim 10, wherein the second electrode is the transparent electrode, and the transparent electrode is disposed on the organic emissive layer.

12. The device of claim 11,
wherein an in-plane dimension of the nanoparticles is at least one selected from the group consisting of: 200-400 nm, 400-600nm, and 600-800 nm, wherein the in-plane dimension is in a plane that is horizontal to the substrate, and
wherein a distance in an out-of-plane dimension between the nanoparticles is at least one selected from the group consisting of: 25-75 nm, 75-200nm, 200-400 nm, and 400-600 nm, wherein the out-of-plane dimension is in a plane perpendicular to the substrate.

13. The device of claim 1,
wherein an in-plane dimension of the nanoparticles is at least one selected from the group consisting of: 200-400 nm, 400-600nm, and 600-800 nm, wherein the in-plane dimension is in a plane that is horizontal to the substrate and
wherein a distance in an out-of-plane dimension between the nanoparticles is at least one selected from the group consisting of: 25-75 nm, 75-200nm, 200-400 nm, and 400-600 nm, wherein the out-of-plane dimension is in a plane perpendicular to the substrate.

14. The device of any one of the previous claims, wherein the device is at least one type selected from the group consisting of: a flat panel display, a curved display, a computer monitor, a medical monitor, a television, a billboard, a light for interior or exterior illumination and/or signaling, a heads-up display, a fully or partially transparent display, a flexible display, a rollable display, a foldable display, a stretchable display, a laser printer, a telephone, a cell phone, tablet, a phablet, a personal digital assistant (PDA), a wearable device, a laptop computer, a digital camera, a camcorder, a viewfinder, a micro-display that is less than 2 inches diagonal, a 3-D display, a virtual reality or augmented reality display, a vehicle, an automotive display, video walls comprising multiple displays tiled together, a theater or stadium screen, and a sign.

15. A device comprising:
an organic light emitting device (OLED) comprising:
a substrate;
a first electrode disposed over the substrate;
a second electrode disposed over the first electrode; and
an organic emissive layer disposed between the first electrode and the second electrode, the organic emissive layer having a first surface positioned over a second surface; and
a nanoparticle layer disposed over the organic emissive layer, the nanoparticle layer having a first surface that is positioned over a second surface, the nanoparticle layer comprising:
a plurality of nanoparticles comprising a dielectric material; and
a surrounding medium;
wherein the organic emissive layer directly couples to Mie scattering modes of the plurality of nanoparticles, and
wherein a distance from the second surface of the nanoparticle layer to the first surface of the organic emissive layer is at least one selected from the group consisting of: not more than 1/5, not more than 1/8, and not more than 1/10 of a peak emission wavelength capable of being emitted by the organic emissive layer.
